# EUROPEAN PATENT APPLICATION

(11) **EP 4 576 230 A1**
(43) Date of publication of application: **25.06.2025**
(21) Application number: 22966826.4
(22) Date of filing: 30.11.2022
(51) Int. Cl.: H01L 33/60, G02F 1/13357

(54) **LIGHT-EMITTING SUBSTRATE AND MANUFACTURING METHOD THEREFOR, BACKLIGHT MODULE AND DISPLAY DEVICE**

(71) Applicant: Boe Technology Group Co., Ltd., Beijing 100015 (CN); Hefei Boe Ruisheng Technology Co., Ltd., Hefei, Anhui 230012 (CN)
(72) Inventor: GENG, Xiaolin, Beijing 100176 (CN); TANG, Hai, Beijing 100176 (CN); LIU, Xing, Beijing 100176 (CN); GAO, Liang, Beijing 100176 (CN); HE, Xiaosong, Beijing 100176 (CN)
(74) Representative: Klunker IP Patentanwälte PartG mbB
(86) International application number: PCT/CN2022/135473
(87) International publication number: WO 2024/113233

(57) **Abstract**

A light-emitting substrate and a manufacturing method therefor, a backlight module and a display device. The light-emitting substrate (200) comprises a first region and a second region, which are alternately arranged in a first direction, and comprises: a base substrate (100), a light-emitting device (120) and a reflecting layer (109), wherein on one side of the base substrate (100), the light-emitting device (120) is arranged in the first region; the reflecting layer (109) comprises a first reflecting layer (109a) and a second reflecting layer (109b), which are respectively located in the first region and the second region and are connected to each other; the reflecting layer (109) is provided with an opening; the light-emitting device (120) is located in the opening and is spaced apart from the reflecting layer (109); the reflecting layer (109) is provided with an edge portion and a main body portion; the edge portion is close to the light-emitting device (120) and defines the opening; the main body portion is located on the side of the edge portion away from the light-emitting device (120); the edge portion comprises at least the portion of the first reflecting layer (109a); the edge portion of the reflecting layer (109) has multiple reflecting edges facing the light-emitting device (120) and defining the opening, and multiple reflecting included angles formed by means of the multiple reflecting edges intersecting; and the multiple reflecting included angles comprise included angles, the shapes or angles of which are not identical.

## Description

### TECHNICAL FIELD

Embodiments of the present disclosure relate to a light-emitting substrate and a manufacturing method thereof, a backlight module, and a display device.

### BACKGROUND

For a passive light-emitting display device, a light source device for disposing a backlight may be included. One implementation of the backlight source may be a light-emitting substrate including light-emitting devices such as submillimeter light-emitting diodes distributed in an array. The light-emitting substrate may further include a reflective layer around the light-emitting device. The formation process and related structural features of the reflective layer will affect the light-emitting characteristics of the light-emitting substrate, such as the light-exiting uniformity.

### SUMMARY

At least one embodiment of the disclosure provides a light-emitting substrate, including a first region and a second region alternately disposed along a first direction, and including: a base substrate; a light-emitting device, disposed on a side of the base substrate and in the first region; and a reflective layer, located on the side of the base substrate, and including a first reflective layer and a second reflective layer respectively located in the first region and the second region and connected to each other, wherein the reflective layer has an opening, and the light-emitting device is located in the opening and spaced apart from the reflective layer; the reflective layer includes an edge part and a body part, the edge part is close to the light-emitting device and defines the opening, the body part is located on a side of the edge part away from the light-emitting device, and the edge part at least includes a portion of the first reflective layer; and the edge part of the reflective layer is provided with a plurality of reflective edges facing the light-emitting device and defining the opening, and a plurality of reflective included angles formed by the plurality of reflective edges intersecting with each other, and the plurality of reflective included angles include included angles that are not completely identical in shape.

In the light-emitting substrate provided by the embodiment of the present disclosure, the plurality of reflective included angles of the reflective layer include at least one of an acute angle, a rounded chamfer, and an obtuse angle.

In the light-emitting substrate provided by the embodiment of the present disclosure, the light-emitting device has a first device side edge extending along the first direction and a second device side edge extending along a second direction, the second direction intersects with the first direction, and a first distance from the first device side edge to the reflective layer in the second direction is substantially equal to a second distance from the second device side edge to the reflective layer in the first direction.

In the light-emitting substrate provided by the embodiment of the present disclosure, the light-emitting device has a plurality of top corners, the plurality of top corners are formed by included angles between the first device side edge and the second device side edge intersecting with each other, the plurality of reflective edges of the reflective layer include a first reflective edge facing the first device side edge and a second reflective edge facing the second device side edge, the plurality of reflective included angles of the reflective layer include a plurality of included angles formed by the first reflective edge and the second reflective edge intersecting with each other, and each of the plurality of included angles of the reflective layer includes an acute angle or a rounded chamfer.

In the light-emitting substrate provided by the embodiment of the present disclosure, the first device side edge of the light-emitting device includes a group of a first side edge and a second side edge extending parallel to each other along the first direction, and the second device side edge of the light-emitting device includes a group of a third side edge and a fourth side edge extending parallel to each other along the second direction; the plurality of reflective edges of the reflective layer include a first edge, a second edge, a third edge, and a fourth edge, respectively facing the first side edge, the second side edge, the third side edge, and the fourth side edge of the light-emitting device, and the plurality of reflective included angles of the reflective layer include a first included angle which is an included angle between the first edge and the third edge, a second included angle which is an included angle between the second edge and the third edge, a third included angle which is an included angle between the first edge and the fourth edge, and a fourth included angle which is an included angle between the second edge and the fourth edge; and the first included angle and the second included angle are included angles of a same type, and the third included angle and the fourth included angle are included angles of a same type.

In the light-emitting substrate provided by the embodiment of the present disclosure, the first edge and the second edge of the reflective layer each include a body part extending along the first direction and end parts located at two ends of the body part, and the third edge and the fourth edge each include a body part extending along the second direction and end parts located at two ends of the body part; and the first included angle to the fourth included angle of the reflective layer are respectively formed by end parts of corresponding edges of the first edge to the fourth edge intersecting with each other, and extension directions of the end parts and the body part of at least one of the first edge to the fourth edge of the reflective layer are different.

In the light-emitting substrate provided by the embodiment of the present disclosure, the first included angle is located on a side of an extension line of the body part of the first edge in the first direction, away from a centerline of the light-emitting device, and the second included angle is located on a side of an extension line of the body part of the second edge in the first direction, away from the centerline of the light-emitting device, and the centerline of the light-emitting device extends along the first direction and passes through a center of the light-emitting device.

In the light-emitting substrate provided by the embodiment of the present disclosure, the third included angle is located on a side of the extension line of the body part of the first edge, close to the centerline of the light-emitting device, and the fourth included angle is located on a side of the extension line of the body part of the second edge, close to the centerline of the light-emitting device.

In the light-emitting substrate provided by the embodiment of the present disclosure, the third included angle is located on a side of the extension line, of the body part of the first edge, away from the centerline of the light-emitting device, and the fourth included angle is located on a side of the extension line, of the body part of the second edge, away from the centerline of the light-emitting device.

In the light-emitting substrate provided by the embodiment of the present disclosure, the first included angle to the fourth included angle are each located on a side of extension lines, of the body parts of the first edge and the second edge in the first direction, close to a centerline of the light-emitting device, and the centerline of the light-emitting device extends along the first direction and passes through a center of the light-emitting device.

In the light-emitting substrate provided by the embodiment of the present disclosure, the end parts of the first edge to the fourth edge on opposite sides of a centerline of the light-emitting device include curves with different curvatures.

In the light-emitting substrate provided by the embodiment of the present disclosure, the first edge and the second edge of the reflective layer each include a first sub-edge and a second sub-edge intersecting with each other, and the reflective layer is provided with a recess, recessed toward the body part of the reflective layer and away from the light-emitting device, at an intersection of the first sub-edge and the second sub-edge.

In the light-emitting substrate provided by the embodiment of the present disclosure, the intersection of the first sub-edge and the second sub-edge is aligned in the second direction with a center point of the first device side edge of the light-emitting device in the first direction.

In the light-emitting substrate provided by the embodiment of the present disclosure, an included angle between the first sub-edge and the second sub-edge is an obtuse angle.

In the light-emitting substrate provided by the embodiment of the present disclosure, each of the third edge and the fourth edge of the reflective layer also includes a first sub-edge and a second sub-edge intersecting with each other, and the reflective layer is provided with a recess, recessed toward the body part of the reflective layer and away from the light-emitting device, at an intersection of the first sub-edge and the second sub-edge.

In the light-emitting substrate provided by the embodiment of the present disclosure, the intersection of the first sub-edge and the second sub-edge of each of the third edge and the fourth edge of the reflective layer is aligned in the first direction with a center point of the second device side edge of the light-emitting device in the second direction.

In the light-emitting substrate provided by the embodiment of the present disclosure, a thickness of the edge part is less than a thickness of the body part.

In the light-emitting substrate provided by the embodiment of the present disclosure, the edge part is ring-shaped and laterally surrounds the light-emitting device.

In the light-emitting substrate provided by the embodiment of the present disclosure, the edge part is a portion of the first reflective layer close to the light-emitting device, and the edge part is spaced apart from the second reflective layer by other portions of the first reflective layer.

In the light-emitting substrate provided by the embodiment of the present disclosure, the edge part includes a first edge part of the first reflective layer and a second edge part of the second reflective layer, and the first edge part and the second edge part enclose to form the opening.

In the light-emitting substrate provided by the embodiment of the present disclosure, a side length of the first edge part is greater than a side length of the second edge part.

In the light-emitting substrate provided by the embodiment of the present disclosure, a thickness of a body part of the first reflective layer is substantially equal to a thickness of a body part of the second reflective layer.

In the light-emitting substrate provided by the embodiment of the present disclosure, the second reflective layer includes a plurality of first reflective strips and second reflective strips arranged alternately along the first direction and extending along a second direction, one of the second reflective strips is located between adjacent first reflective strips, and overlaps with the adjacent first reflective strips in a direction perpendicular to a main surface of the base substrate.

In the light-emitting substrate provided by the embodiment of the present disclosure, a plurality of the first regions and a plurality of the second regions are arranged alternately along the first direction, and the light-emitting device includes a plurality of light-emitting devices arranged in an array in the plurality of the first regions.

In the light-emitting substrate provided by the embodiment of the present disclosure, an additional device arranged between adjacent light-emitting devices in the first direction is further included, wherein in the first direction, a pitch between adjacent additional devices is an integer multiple of a pitch between the adjacent light-emitting devices.

In the light-emitting substrate provided by the embodiment of the present disclosure, the reflective layer further includes an additional opening, and the additional device is disposed in the additional opening of the reflective layer and spaced apart from the reflective layer.

An embodiment of the present disclosure provides a manufacturing method of a light-emitting substrate, wherein the light-emitting substrate includes a first region and a second region alternately disposed along a first direction, and the manufacturing method includes: providing a base substrate; forming a conductive pad over the base substrate; bonding a light-emitting device to the conductive pad, wherein the light-emitting device is disposed in the first region; and forming a reflective layer over the base substrate by using a 3D printing process after bonding the light-emitting device, wherein forming the reflective layer includes forming a first reflective layer in the first region and forming a second reflective layer in the second layer, and the first reflective layer and the second reflective layer are connected to each other; the reflective layer is provided with an opening, and the light-emitting device is located in the opening and spaced apart from the reflective layer; the reflective layer includes an edge part and a body part, the edge part is close to the light-emitting device and defines the opening, the body part is located on a side of the edge part away from the light-emitting device, and the edge part at least includes a portion of the first reflective layer; and the edge part of the reflective layer is provided with a plurality of reflective edges facing the light-emitting device and defining the opening, and a plurality of reflective included angles formed by the plurality of reflective edges intersecting with each other, and the plurality of reflective included angles include included angles that are not completely identical in shape or angle degree.

In the manufacturing method of the light-emitting substrate provided by the embodiment of the present disclosure, the 3D printing process includes printing the first reflective layer in the first region by using a first print head and printing the second reflective layer in the second region by using a second print head, a plurality of reflective strips are printed in the first region and the second region by the first print head and the second print head each according to a predetermined printing path, and the plurality of reflective strips are merged together with each other to form the reflective layer.

In the manufacturing method of the light-emitting substrate provided by the embodiment of the present disclosure, a dimension of a spray valve of the first print head is smaller than a dimension of a spray valve of the second print head; printing the first reflective layer includes that the first print head travels along a first sub-path in a second direction to print a first sub-reflective strip, then moves in the first direction by a first offset distance, and travels in the second direction along a second sub-path opposite to a direction of the first sub-path to print a second sub-reflective strip; printing the second reflective layer includes that the second print head travels along a third sub-path in the second direction to print a third sub-reflective strip, then moves in the first direction by a second offset distance, and travels in the second direction along a fourth sub-path opposite a direction of the third sub-path to print a fourth sub-reflective strip; and the first offset distance is less than the second offset distance.

In the manufacturing method of the light-emitting substrate provided by the embodiment of the present disclosure, the first sub-reflective strip and the second sub-reflective strip overlap with each other in a direction perpendicular to a main surface of the base substrate, the third sub-reflective strip and the fourth sub-reflective strip overlap with each other in the direction perpendicular to the main surface of the base substrate, and a width of an overlapping region of the first sub-reflective strip and the second sub-reflective strip in the second direction is greater than a width of an overlapping region of the third reflective strip and the fourth reflective strip in the second direction.

In the manufacturing method of the light-emitting substrate provided by the embodiment of the present disclosure, printing the first reflective layer further includes: when the first print head travels to a position close to the light-emitting device, changing a moving direction of the first print head to bypass the light-emitting device, and printing an edge reflective material layer along a periphery of the light-emitting device at a position separated from the light-emitting device by a predetermined distance, wherein a boundary of at least a portion of the opening of the reflective layer is defined by the edge reflective material layer printed by the first print head.

In the manufacturing method of the light-emitting substrate provided by the embodiment of the present disclosure, the first print head prints a first edge reflective strip along a part of the periphery of the light-emitting device, and printing the second reflective layer further includes: printing a second edge reflective strip, wherein the second edge reflective strip and the first edge reflective strip are connected to each other and enclose to form the opening.

In the manufacturing method of the light-emitting substrate provided by the embodiment of the present disclosure, a boundary of the opening of the reflective layer is entirely defined by the edge reflective material layer printed by the first print head, and printing the edge reflective material layer by the first print head includes printing an ring-shaped edge reflective strip by the first print head along an ring-shaped path surrounding the light-emitting device, or printing a plurality of edge sub-reflective strips by the first print head along a plurality of edge sub-paths surrounding the light-emitting device, and the plurality of edge sub-reflective strips are connected to each other and enclose to define the opening.

In the manufacturing method of the light-emitting substrate provided by the embodiment of the present disclosure, printing the second reflective layer includes printing a first group of reflective strips by using a first group of spray valves, and printing a second group of reflective strips by using a second group of spray valves, the first group of reflective strips include a plurality of first reflective strips, the second group of reflective strips include a plurality of second reflective strips, and the plurality of first reflective strips and the plurality of second reflective strips are arranged along the first direction and extending along a second direction, the plurality of first reflective strips are spaced apart from each other, and the plurality of second reflective strips are printed between the plurality of first reflective strips to fill gaps between the plurality of first reflective strips, wherein the first group of reflective strips and the second group of reflective strips overlap with each other in a direction perpendicular to a main surface of the base substrate.

An embodiment of the present disclosure provides a backlight module, including any one of the above-mentioned light-emitting substrates, and an optical film layer located on a light-exiting side of the light-emitting substrate.

An embodiment of the present disclosure provides a display device, including the above-mentioned backlight module, and a display panel located on a side of the backlight module.

### BRIEF DESCRIPTION OF DRAWINGS

In order to clearly illustrate the technical solution of the embodiments of the present disclosure, the drawings of the embodiments will be briefly described. It is obvious that the described drawings in the following are only related to some embodiments of the present disclosure and thus are not limitative of the present disclosure.

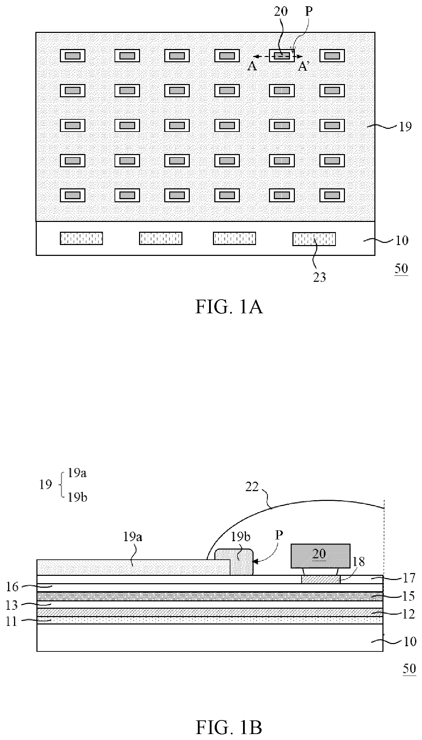

FIG. 1A and FIG. 1B are schematic plan view and cross-sectional view of a light-emitting substrate according to some embodiments of the present disclosure.

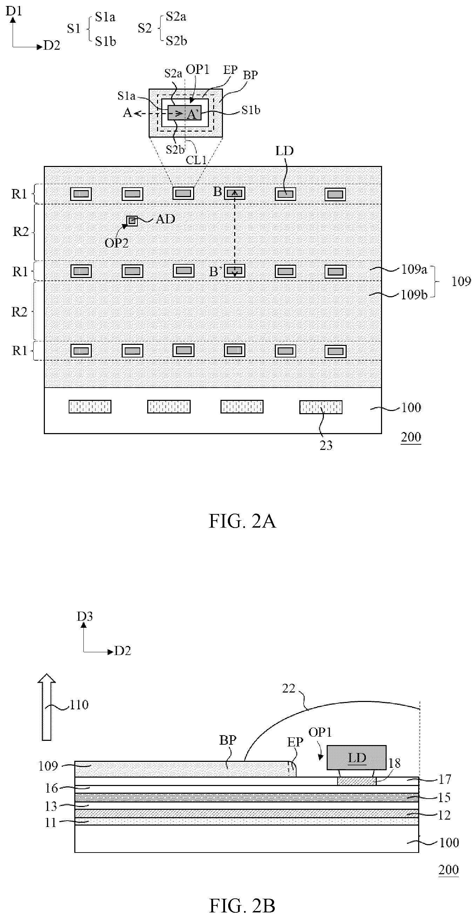

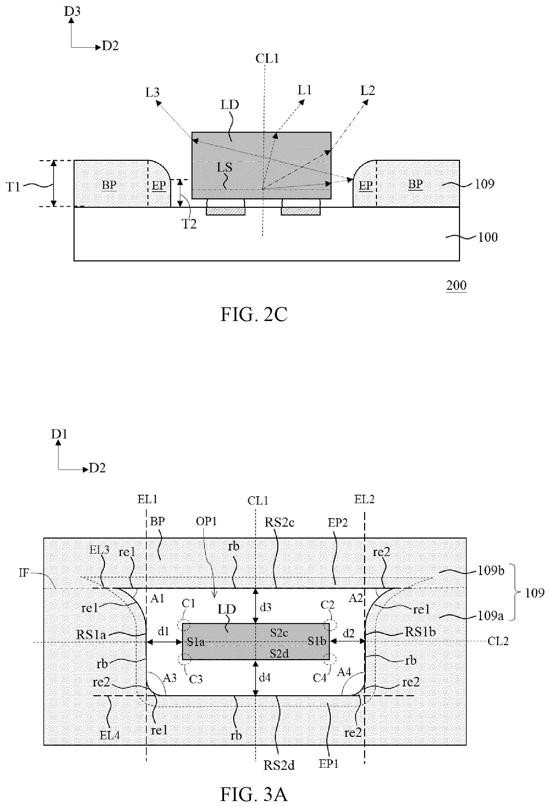

FIG. 2A and FIG. 2B are schematic plan view and cross-sectional view of a light-emitting substrate according to other embodiments of the present disclosure, and FIG. 2C illustrates the light-exiting manner of a light-emitting device in a light-emitting substrate according to some embodiments of the present disclosure.

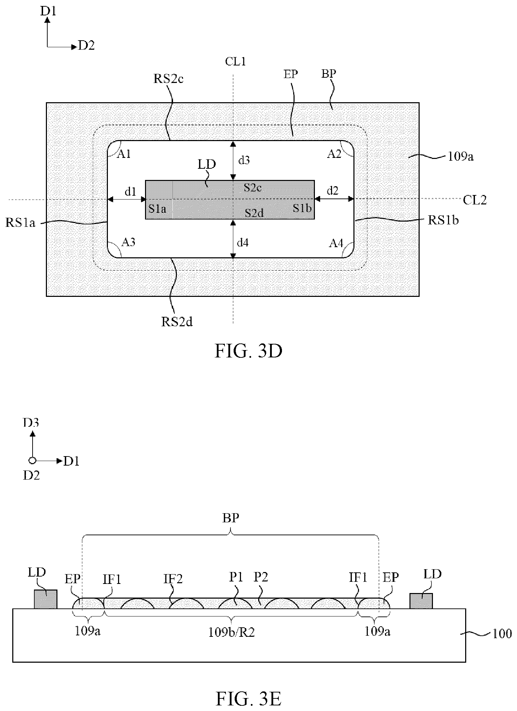

FIG. 3A to FIG. 3D illustrate schematic plan views of a light-emitting device and a reflective layer therearound of the light-emitting substrate according to some embodiments of the present disclosure, and FIG. 3E illustrates a schematic cross-sectional view of a light-emitting device and a reflective layer of a light-emitting substrate according to some embodiments of the present disclosure.

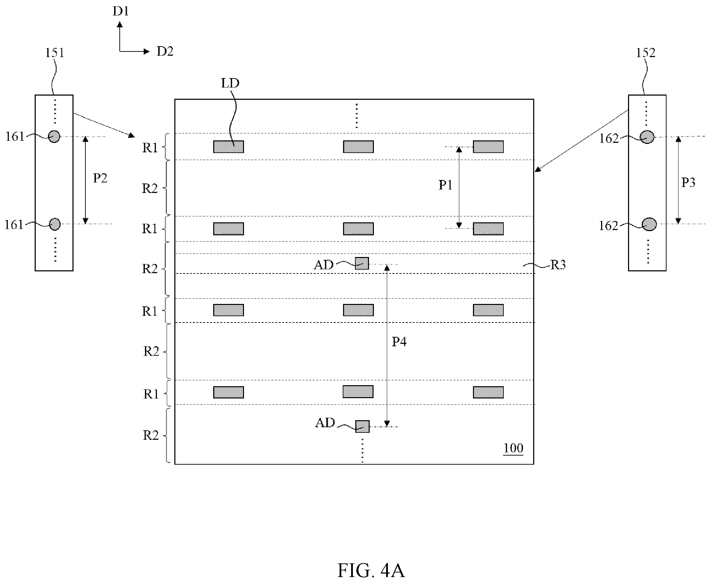

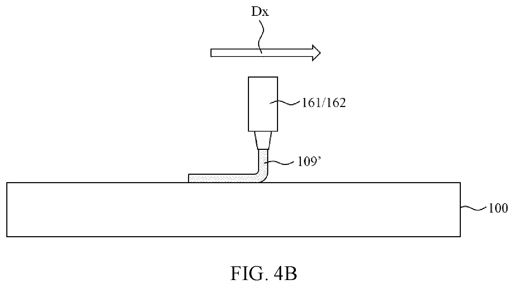

FIG. 4A illustrates a schematic plan view of a light-emitting substrate after bonding a light-emitting device and before forming a reflective layer, and a print head required for a corresponding 3D printing process according to some embodiments of the present disclosure, and FIG. 4B illustrates a schematic cross-sectional view of printing a reflective strip on a base substrate using a 3D printing process according to some embodiments of the present disclosure.

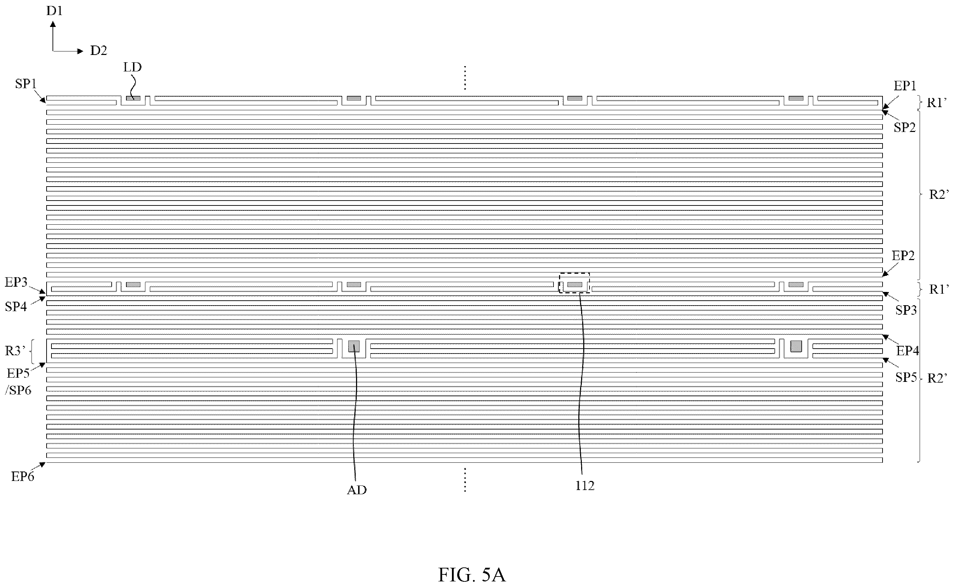

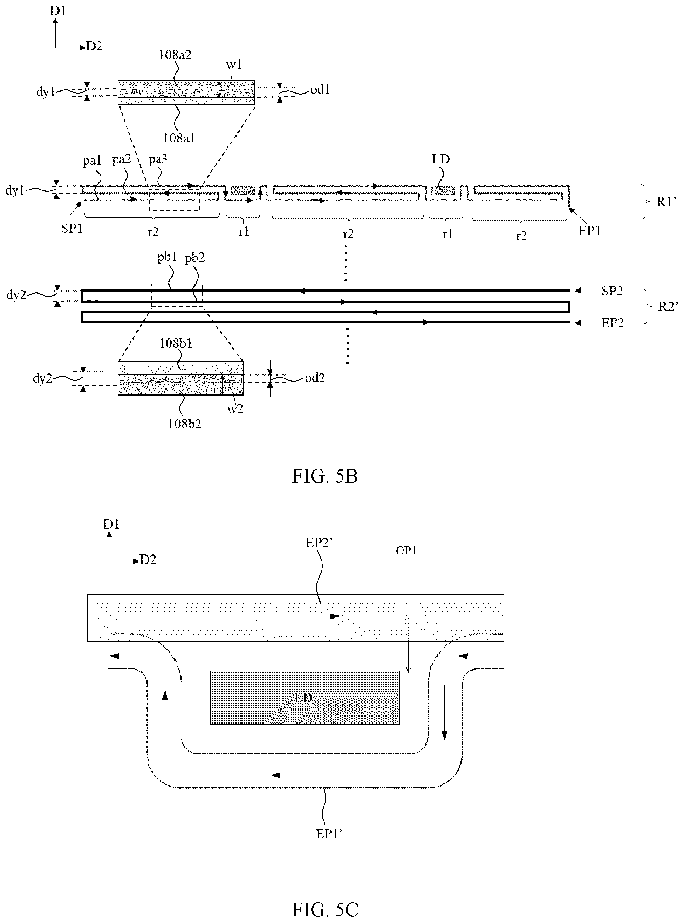

FIG. 5A illustrates a schematic view of a printing path for forming a reflective layer using a 3D printing process according to some embodiments of the present disclosure, FIG. 5B illustrates a schematic enlarged view of a part of the printing path in FIG. 5A and a sub-reflective strip formed therein, and FIG. 5C illustrates a schematic enlarged view of a printing path of a region 112 in the FIG. 5A.

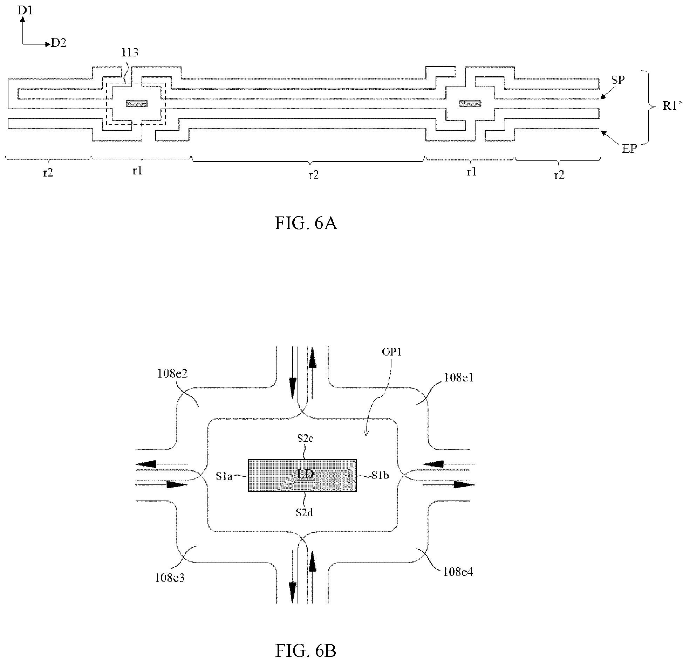

FIG. 6A, FIG. 7A and FIG. 8A respectively illustrate a schematic view of a printing path in a first print region according to some embodiments of the present disclosure, and FIG. 6B, FIG. 7B and FIG. 8B respectively illustrate schematic enlarged views of a printing path in a region 113 in FIG. 6A, FIG. 7A and FIG. 8A.

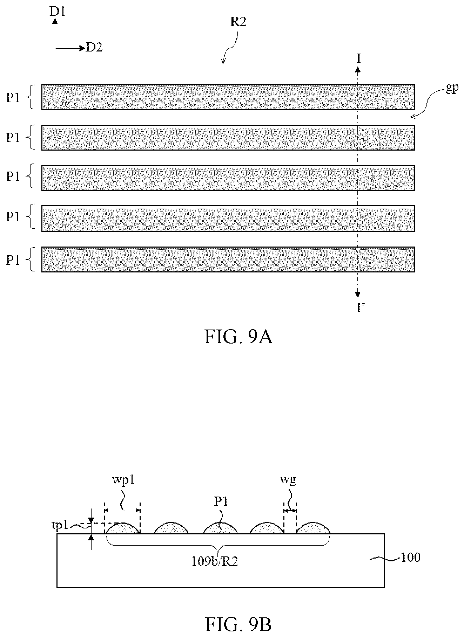

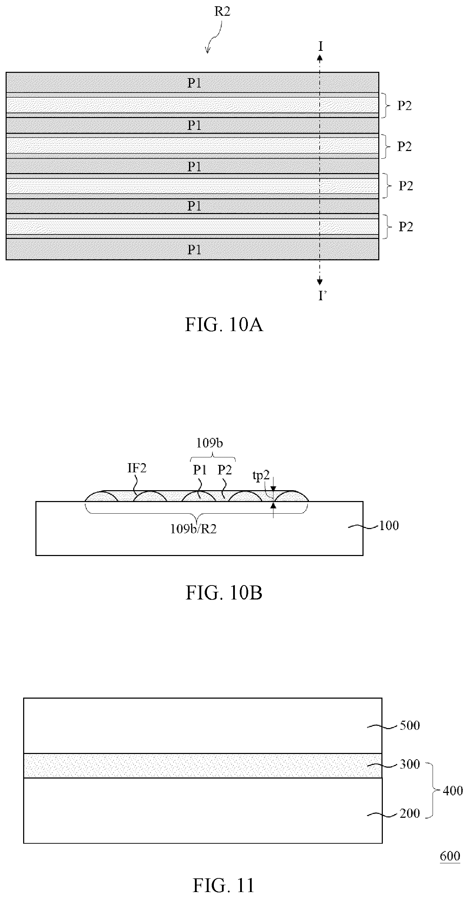

FIG. 9A, FIG. 9B, FIG. 10A and FIG. 10B illustrate schematic plan views and cross-sectional views of a printing method for forming a reflective layer in a second print region according to some embodiments of the present disclosure.
FIG. 11 illustrates a schematic cross-sectional view of a display device according to some embodiments of the present disclosure.

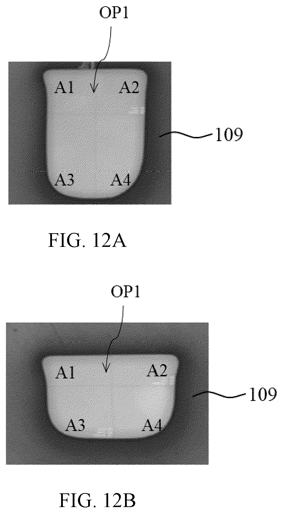

FIG. 12A and FIG. 12B each illustrate a physical photo of an opening of a reflective layer according to some embodiments of the present disclosure.

### DETAILED DESCRIPTION

In order to make objects, technical details and advantages of the embodiments of the present disclosure apparent, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., used in the present disclosure are not intended to indicate any sequence, amount or importance, but distinguish different components. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not limited to a physical connection or mechanical connection, but may also include an electrical connection, directly or indirectly.

FIG. 1A and FIG. 1B are respectively a schematic top view and a schematic cross-sectional view of a light-emitting substrate according to some embodiments of the present disclosure, and FIG. 1B is a cross-sectional view taken along line A-A' of FIG. 1A.

Referring to FIG. 1A and FIG. 1B, in some embodiments, a light-emitting substrate 50 includes a base substrate 10, a reflective layer 19 and a light-emitting device 20. The reflective layer 19 is disposed with a plurality of openings P, and a plurality of light-emitting devices 20 are correspondingly disposed in the plurality of openings P of the reflective layer 19. The plurality of light-emitting devices 20 may be arranged in an array, and may be used as a light source of the light-emitting substrate 100. The light-emitting device 20 is disposed in the opening of the reflective layer 19, and the reflective layer 19 can reflect the light emitted by the plurality of light-emitting devices 20, thereby improving the light utilization efficiency of the light-emitting device 20 and improving the brightness of the light-emitting substrate. In addition, the reflective layer 19 may also be used as a protective layer to prevent the light-emitting substrate 50 from being corroded by water and oxygen and from being scratched and damaged.

In some embodiments, the light-emitting substrate 50 further includes a transition layer 11, a conductive layer 12, a passivation layer 13, a protective layer 15, passivation layers 16 and 17, and a conductive layer 18 disposed on the base substrate 10. The transition layer 11 may be disposed between the base substrate 10 and the conductive layer 12 for increasing the adhesion between the conductive layer 12 and the base substrate 10. For example, the transition layer includes a material such as silicon oxide, silicon nitride, or the like. The light-emitting substrate 50 may include one or more conductive layers, such as a plurality of conductive layers 12 and 18, the plurality of conductive layers may be electrically connected to each other through a plurality of via holes (not illustrated), and may be or include signal wires to dispose signals for the light-emitting devices 20. The conductive layer may include metal materials such as copper, etc.

In some embodiments, the passivation layers 13, 16, 17 are disposed close to the conductive layers 12 and 18 for protecting the corresponding conductive layers. For example, the plurality of passivation layers can dispose insulation protection for corresponding conductive layers, preventing the conductive layers from being subjected to electromagnetic interference. The plurality of passivation layers may each include an insulation material such as silicon nitride, etc., and may include the same or different materials from each other.

In some embodiments, the protective layer 15 is disposed between the adjacent passivation layers 13 and 16, and the protective layer 15 can be configured to protect the underlying components, for example, to isolate water and oxygen. The protective layer 15 may include a material such as resin, etc.

In some embodiments, the light-emitting substrate further includes a bonding structure 23 in a bonding region, which is close to an edge of the light-emitting substrate. The bonding structure 23 can be electrically connected to electronic components (for example, a driver chip, etc.) in the light-emitting substrate, and bonded to other electronic devices (for example, an integrated circuit (IC), a printed circuit board, etc.), and used for the transmission of electrical signals between the electronic components in the light-emitting substrate and the electronic devices. In some embodiments, the reflective layer 109 does not cover the bonding region of the light-emitting substrate.

The light-emitting device 20 is electrically connected to the conductive layer 18, and may be bonded to a pad (or may be referred to as a conductive pad) of the conductive layer 18, for example, through a soldering process. In some embodiments, the light-emitting substrate 50 further includes a protective lens 22 covering on the light-emitting device 20. The protective lens 22 can protect the light-emitting unit and can also gather light, thereby improving the light-emitting brightness of the light-emitting device 20.

In some embodiments, the reflective layer 19 includes a main reflective layer 19a and a supplementary reflective layer 19b. For example, the main reflective layer 19a is formed above the base substrate 10 by a screen printing process, and the main reflective layer 19a is disposed with an opening to expose the pad of the conductive layer 18 and its surrounding region; then the light-emitting device 20 is soldered to the pad of the conductive layer 18; in some embodiments, the process of bonding the light-emitting device to the conductive pad is called a die-bonding process; after that, the supplementary reflective layer 19b is formed by a supplementary filling process, and the main body reflective layer 19a and the supplementary reflective layer 19b are connected to each other, and overlap with each other in a direction perpendicular to a main surface of the substrate 10 .

In some embodiments, because the accuracy of the screen printing process is relatively low, when forming the main reflective layer 19a, the opening of the reflective layer is set to be relatively large to prevent the reflective layer material from polluting a soldering region of the light-emitting device 20; after the main reflective layer 19a is formed, the light-emitting device 20 is soldered on the conductive layer pad exposed by the opening of the main reflective layer 19a. Afterwards, a dot-filling process is performed to form the supplementary reflective layer 19b to fill part of the openings of the main reflective layer 19a, and the main reflective layer 19a and the supplementary reflective layer 19b together serve as the reflective layer 19, so that the area of the opening can be reduced and the area of the reflective layer 19 can be increased, thereby increasing the reflectivity of the reflective layer 19 and increasing the brightness of the light-emitting substrate 50.

In some other embodiments, a reflective material layer is formed on the entire surface of the base substrate, and then the reflective material layer is patterned through an exposure and development process to form the reflective layer 19 with a plurality of openings and expose the soldering regions of the light-emitting devices.

In the above-mentioned embodiments, the manufacturing method of the reflective layer 19 includes forming a reflective material (for example, white oil) on the surface of the light-emitting substrate, and then curing the reflective material. However, the reflective material is composed of high-reflectivity solutes and solvents. During the curing process of the reflective material, the precipitates of the reflective material will adhere to the conductive pad used to connect with the light-emitting device, and form a solder resist layer on the surface of the pad, which will reduce the solderability of the pad and reduce the soldering reliability of the light-emitting device. In some manufacturing methods of the light-emitting substrate, before the die-bonding process, an electroless nickel/immersion gold process is added, and a nickel-gold layer is plated on the pad to improve the soldering performance and anti-corrosion performance of the pad. The reflective layer is prepared after the gold melting process, during the curing process of the reflective material, the precipitates of the reflective material will still adhere to the surface of the nickel-gold layer of the pad to form a solder resist layer, which will affect the soldering performance of the pad. Even if the gold melting process is performed after the reflective layer is manufactured, the precipitates of the reflective material on the surface of the pad cannot be removed, resulting in a greatly reduced yield of gold melting.

On the other hand, in the embodiment where the reflective layer is formed by screen printing process combined with dot-filling process, the shape accuracy of the reflective layer is low, and the gap between the light-emitting device and the reflective layer can only reach the level of 0.3 mm ± 0.15 mm. This large gap may cause light leakage, and it may be difficult to reflect all the light emitted by the light-emitting device and irradiated on the reflective layer, resulting in defects such as optical bright and dark strips and display unevenness (mura) occurred to the light-emitting substrate and display module. In the embodiment where the reflective layer is formed by exposure and development, although the precision of the reflective layer is improved, the gap between the light-emitting device and the reflective layer is usually set at 0.1 mm due to the need to consider the die-bonding precision and the like in the die-bonding process. In addition, the die-bonding process includes a reflow process. Due to the high temperature of the reflow process, the reflow process will cause the material of the previously formed reflective layer to oxidize and turn yellow, which in turn will reduce the reflectivity of the reflective layer (for example, the reflectivity is attenuated by 1%~2%), resulting in attenuation of the light-emitting brightness of the light-emitting substrate, such as attenuation of 3%-5%, which in turn leads to a decrease in the brightness of the light-emitting module and the display device.

In view of the above-mentioned problems, the embodiments of the present disclosure dispose a light-emitting substrate and a manufacturing method thereof. The method includes, after forming the respective material layers and conductive pads on the base substrate, firstly (bonding light-emitting devices and/or other to-be-bonded devices to the conductive pads on the base substrate, for example, through a die-bonding process including soldering, and then forming a reflective layer by a 3D printing process, for example. In some embodiments, the light-emitting device is bonded using needle-punched die-bonding device. Because the reflective layer has not been formed during the die-bonding process, the distance between the die-bonding device and the conductive pad of the light-emitting device can be minimized, thereby improving the die-bonding accuracy and die-bonding yield. On the other hand, forming the reflective layer after bonding the light-emitting devices and/or other additional devices can avoid the influence of the precipitates of the reflective layer material on the soldering effect in the above-mentioned embodiment, thereby improving the die-bonding yield. In addition, compared to the case that part of the reflective layer material may remain on printing tools such as the screen printing plate during the screen printing process, and the formed reflective layer opening may have burrs, the embodiments of the present disclosure use the 3D printing process to print the reflective material, through which the loss of the reflective material can be reduced, and the reflective layer opening with a smooth surface can be formed, thereby improving the light-exiting uniformity of the light-emitting substrate. On the other hand, using the 3D printing process to form the reflective layer after bonding the light-emitting device can avoid problems such as the decrease in the reflectivity of the reflective layer caused by the reflow process in the die-bonding process, thereby improving the light efficiency of the light-emitting substrate. Moreover, the dot-filling process can be eliminated to reduce the hightemperature curing process of the substrate. Furthermore, the 3D printing process has high precision (for example, the difference between the relative dimension of the gap between the formed reflective layer and the light-emitting device and a predetermined dimension can be controlled within the range of ±50 µm), and for example, the gap between the light-emitting device and the reflective layer can be controlled within the range of 0.1 mm±50 µm, thereby improving the light efficiency and avoiding obvious strips and mura on the light-emitting substrate.

In the embodiments of the present disclosure, the reflective layer openings formed by printing with a specific printing path using a 3D printing process may include a plurality of included angles that are not completely identical in shape and/or angle; by setting the distance from respective side edges of the light-emitting device to the reflective layer to be substantially the same, the light emitted from the respective side edges of the light-emitting device is reflected by the reflective layer in substantially the same manner, thereby improving the light-exiting uniformity of the light-emitting substrate. In addition, the reflective layer includes an edge part close to the light-emitting device and a body part on a side of the edge part away from the light-emitting device, and the thickness of the edge part of the reflective layer is set to be less than the thickness of the body part; a part of the light emitted by the light-emitting device is directly emitted from a top wall or side wall of the light-emitting device, while the other part of the light is reflected by the edge part of the reflective layer and then emitted, and the light consumption of the other part of the light is relatively large. In the embodiments of the present disclosure, by setting the thickness of the edge part of the reflective layer to be less than the thickness of the body part, the proportion of the other part of the light of the light-emitting device can be reduced, thereby reducing the light consumption and improving the light-exiting efficiency.

FIG. 2A and FIG. 2B illustrate schematic top and cross-sectional views of a light-emitting substrate according to some embodiments of the present disclosure, FIG. 2B is a cross-sectional view taken along a line A-A' of FIG. 2A.

Referring to FIG. 2A and FIG. 2B, in some embodiments, the light-emitting substrate 200 includes a base substrate 100, and light-emitting devices LD and a reflective layer 109 located on a side of the base substrate 100. Similar to the foregoing embodiment, the light-emitting substrate 200 may further include a transition layer 11, a conductive layer 12, a passivation layer 13, a protective layer 15, passivation layers 16 and 17, and a conductive layer 18 that are located between the base substrate 100 and the reflective layer 109, and between the base substrate 100 and the light-emitting devices LD, and may further include a protective lens 22 covering on the light-emitting device LD. The reflective layer 109 may be disposed on a side of the passivation layer 17 away from the base substrate 100, and the light-emitting device LD is bonded to the conductive pad of the conductive layer 18.

The base substrate 100 may be a flexible substrate, and may include a material such as polyethylene terephthalate (PET), polyethylene naphthalate (PEN), polyimide (PI) or the like; or the base substrate 100 may be a rigid substrate, and may include a material such as glass, or the like; or the base substrate 100 may be a printed circuit board (PCB), or the like, but the present disclosure is not limited thereto. The light-emitting device LD may be or include a light-emitting chip, a light-emitting diode (LED), a submillimeter light-emitting diode (Mini LED), or a micro light-emitting diode (Micro LED), or the like. The reflective layer 109 can reflect the light irradiated thereon to the light-exiting direction 110 of the light-emitting substrate 200, so as to improve the light utilization efficiency of the light emitted by the light-emitting device LD, and further improve the light efficiency of the light-emitting substrate 200. The light-exiting direction 110 is, for example, toward a side of the reflective layer 109 away from the base substrate 100.

In some embodiments, the reflective layer 109 is provided with an opening OP1, and the light-emitting device LD is disposed in the opening OP1 of the reflective layer 109 and spaced apart from the reflective layer 109, that is, a gap is provided between the light-emitting device LD and the reflective layer 109. In some embodiments, a plurality of light-emitting devices LD may be arranged on the base substrate 100 in an array including a plurality of rows and columns, for example, along a direction D1 and a direction D2, the direction D1 and the direction D2 are parallel to a main surface of the base substrate 100 and intersect with each other, for example, substantially perpendicular to each other. The direction D1 and the direction D2 may be referred to as a first direction and a second direction, respectively, or vice versa. It should be understood that, herein, the direction D1 may include a direction (for example, upward) indicated by the arrow in the figure, and may also include a direction (for example, downward) opposite to the direction indicated by the arrow in the figure; the direction D2 may include a direction (e.g., to the right) indicated by the arrow in the figure, and may also include a direction (e.g., to the left) opposite to the direction indicated by the arrow in the figure. Correspondingly, the reflective layer 109 may be provided with a plurality of openings OP1, and the plurality of openings OP1 are also arranged in an array including a plurality of rows and a plurality of columns along the direction D1 and the direction D2, and are arranged correspondingly to the plurality of light-emitting devices LD. The opening OP1 may also be referred to as a reflective layer opening. In some embodiments, each opening OP1 corresponds to one light-emitting device LD, so that each light-emitting device LD is located in one corresponding opening OP1, that is, the openings OP1 of the reflective layer 109 are in oneto-one correspondence with the light-emitting devices LD. The dimensions of the plurality of light-emitting devices LD and their relative positional relationship with the reflective layer openings are substantially the same, so as to improve the light-exiting uniformity of the light-emitting substrate.

In some embodiments, the light-emitting device LD is provided with a first device side edge S1 extending along the direction D1 and a second device side edge S2 extending along the direction D2, and the distance from the first device side edge S1 to the reflective layer 109 in the direction D2 is substantially equal to the distance from the second device side edge S2 to the reflective layer 109 in the direction D1. The distance from a device side edge of the light-emitting device to the reflective layer may also be referred to as the width of the gap between the light-emitting device and the reflective layer. In some embodiments, the reflective layer 109 is formed by the 3D printing technology, and by setting the printing path, the predetermined distances from the respective device side edges of the light-emitting device to the reflective layer are set to be equal to each other. And herein, the distances from the respective side edges of the first device side edge and the second device side edge to the reflective layer being substantially equal to each other may include the distances from the respective side edges to the reflective layer being completely equal to each other, that is, the case where the difference between the distances from the respective side edges to the reflective layer and the predetermined distance is 0; and may also include the case where the difference between the respective distances from the respective device side edges to the reflective layer and the predetermined distance is within an acceptable error range (for example, 0~±50 µm); for example, using the reflective layer formed by the printing method of the present disclosure, the difference between the distance from each device side edge to the reflective layer and the predetermined distance (e.g., 0.1 mm) can be controlled within 0~±50 µm. In the embodiments of the present disclosure, by setting the light-emitting device LD and the reflective layer 109 as described above, the light emitted from different side edges of the light-emitting device LD can be reflected by the reflective layer 109 in substantially the same manner, for example, the angle (e.g., reflection angle/exit angle, etc.) and/or the amount of the part of light emitted after being reflected by the reflective layer 109 are substantially the same, so that the light emitted from the different side edges of the light-emitting device and its surroundings to be more uniform, thereby improving the light-exiting uniformity of the light-emitting substrate. In addition, the aforementioned distances from the corresponding side edges of different light-emitting devices LD to the reflective layer 109 may be substantially equal to each other to further improve the light-exiting uniformity of the light-emitting substrate. In some embodiments, the embodiments of the present disclosure use the 3D printing technology to print and form the reflective layer in a specific path, so that the reflective layer and the light-emitting device have the above-mentioned positional relationship, and the specific forming process will be described in detail later.

In some embodiments, the light-emitting substrate 200 includes first regions R1 and second regions R2 alternately arranged along the direction D1. The first region R1 extends along the direction D2, and the light-emitting device LD is located in the first region R1. In some embodiments, each first region R1 may include one or more light-emitting devices LD, for example, in the same first region R1, a plurality of light-emitting devices LD are arranged in a row along the direction D2; and a plurality of light-emitting devices LD in different first regions R1 are correspondingly aligned with each other to be arranged in a column in the direction D1. In some embodiments, the first region R1 may also be called a light-emitting device region. The second region R2 may be located between adjacent first regions R1, and the second region R2 may be not provided with a light-emitting device, but may be provided with other types of devices, such as one or more additional devices AD. The additional device AD may be a driver chip for driving the light-emitting device to emit light, or the like. In some embodiments, the reflective layer 109 is not provided with a reflective layer opening in the second region R2. In some embodiments, the reflective layer 109 is provided with a reflective layer opening (or may be referred to as an additional opening) OP2 in the second region R2 to expose the additional device AD. That is, the additional device AD is located in the reflective layer opening OP2. The dimension of the additional device AD may be the same or different from the dimension of the light-emitting device, and the dimensions of the reflective layer openings OP1 and OP2 may be the same or different. In some embodiments, one or more second regions R2 each include the additional device AD, and some second regions R2 do not include the additional device AD. It should be understood that the numbers of the light-emitting devices LD and the additional devices AD illustrated in the figure are only for illustration, and the present disclosure is not limited thereto.

In some embodiments, the reflective layer 109 includes a reflective layer 109a (or may be referred to as a first reflective layer) in the first region R1 and a reflective layer 109b (or may be referred to as a second reflective layer) in the second region R2. The reflective layer 109a and the reflective layer 109b are connected to each other and can be formed by printing with the same or different printing spray valves. In some embodiments, the opening OP1 of the reflective layer is located in the first region R1, and the opening OP1 may be completely defined by the reflective layer 109a, or may be defined by both the reflective layers 109a and 109b.

In some embodiments, the second region R2 is not provided with a reflective layer opening; in some other embodiments, the second region R2 is provided with a reflective layer opening for exposing the additional device; in still some embodiments, one or more second regions R2 are provided with reflective layer opening(s), while another second regions R2 are not provided with a reflective layer opening. The reflective layer opening in the second region R2 may be defined by part of the reflective layer 109b, or may also be defined by both the reflective layers 109a and 109b.

In some embodiments, the reflective layer 109 includes a body part BP and an edge part EP, the edge part EP is close to the light-emitting device LD and defines the opening OP1, and the body part BP is located on a side of the edge part EP away from the light-emitting device LD in a direction parallel to the main surface of the base substrate 100. In some embodiments, the edge part EP is ring-shaped and surrounds the light-emitting device LD. That is to say, the reflective layer 109 may include a plurality of edge parts EP defining the openings OP1, and the plurality of edge parts EP are spaced apart from each other. The body part BP is connected to the plurality of edge parts EP, and is located around the plurality of edge parts EP, and surrounds the plurality of edge parts EP. The body part BP is a continuous portion and has a substantially uniform thickness, the thickness of the edge part EP may be less than the thickness of the body part BP, and the thicknesses of the plurality of edge parts EP may be substantially equal to each other.

FIG. 2C schematically illustrates some light-exiting manners of the light-emitting substrate 200. It should be understood that, for the sake of simplicity and clarity of the drawings, FIG. 2C does not illustrate the components of the light-emitting substrate 200 in detail.

Referring to FIG. 2C, in some embodiments, the light emitted from a light-emitting surface LS of the light-emitting device LD may exit through the paths L1, L2, and L3. For example, a part of the light emitted by the light-emitting device LD exits from its top wall away from the light-emitting substrate 100 through the path L1, a part of the light exits from a side wall of the light-emitting device LD through the path L2, and another part of the light exits from a side wall of the light-emitting substrate 100, and then reflected back to the light-emitting device LD by the edge part EP of the reflective layer 109 and exits from another side wall or the top wall of the light-emitting device LD through the path L3. The light through the path L1 and the path L2 directly exits from the top wall or the side wall of the light-emitting device LD without passing through the reflective layer 109, and the light consumption of this part of light is less. The light emitted through the path L3 is reflected by the edge part EP of the reflective layer 109 and then exits the light-emitting device LD, resulting in that the light consumption is relatively large. By setting the thickness of the edge part EP of the reflective layer 109 close to the light-emitting device LD to be less than the thickness of the body part BP, the embodiments of the present disclosure can reduce the case that light is reflected by the reflective layer 109 and then exits, that is, in the light emitted by the light-emitting device 120, the proportion of light exits from the path C is reduced, thereby reducing the light consumption of the light-emitting device, improving the light-emitting efficiency of the light-emitting substrate 200, and improving the brightness of the light-emitting substrate.

In some embodiments, the edge part EP is provided with a side wall and an arc-shaped surface facing the light-emitting device LD, such that the thickness of the edge part EP decreases as being closer to the light-emitting device LD. For example, the body part BP has a thickness T1, and a portion of the edge part EP closest to the light-emitting device LD has a thickness T2. The thickness T2 is less than the thickness T1, and the thickness of the edge part EP gradually decreases from the thickness T1 to the thickness T2 as being away from the body part BP and approaching the light-emitting device LD, and the thickness T2 may be greater than or equal to zero. In some embodiments, the edge part EP is disposed symmetrically with respect to a centerline CL1 of the light-emitting device LD, for example, the centerline CL1 extends through a center of the light-emitting device LD in the direction D2, and the centerline CL1 may extend along the direction D1 parallel to the main surface of the base substrate 100, or may extend along a direction D3 perpendicular to the main surface of the base substrate 100. In some embodiments, the thicknesses of portions of the edge part EP facing different side edges are substantially the same. By the above-mentioned setting, the uniformity of light exited after being reflected from the edge part of the reflective layer 109 can be improved on the basis of reducing light consumption, and thus the light-exiting uniformity of the light-emitting substrate can be improved.

In some embodiments, when viewed from a plan view, the light-emitting device LD may have a shape such as a rectangle, a square, etc., and the opening OP1 of the reflective layer 109 may have a shape similar to the shape of the light-emitting device, for example, may have a shape such as a rectangle, a square, a rectangle with rounded corners, a square with rounded corners, or other irregular shapes. It should be understood that the above-mentioned shapes of the light-emitting device LD and the reflective layer opening OP1 are only illustrative, and the present disclosure is not limited thereto. In some embodiments, the light-emitting device LD is disposed concentrically with the opening OP1 of the reflective layer 109, or the light-emitting device LD is centered in the opening OP1. In some embodiments where the reflective layer opening OP1 has an irregular shape, the reflective layer opening OP1 is disposed in a symmetrical shape, and the distance from a first device side edge of the light-emitting device LD to the reflective layer is substantially equal to the distance from a second device side edge of the light-emitting device LD to the reflective layer. By the above-mentioned setting of the reflective layer 109, the light emitted from different side edges of the light-emitting device LD through the path L3 can be reflected by the reflective layer 109 in substantially the same manner, thereby improving the light-exiting uniformity of the light-emitting substrate 200.

FIG. 3A to FIG. 3D illustrate schematic enlarged plan views of the light-emitting device and part of the reflective layer surrounding the light-emitting device in the first region of FIG. 2A according to some embodiments of the present disclosure. FIG. 3E illustrates a schematic cross-sectional view along a line B-B' of FIG. 2A according to some embodiments of the present disclosure, which illustrates a schematic view of a light-emitting device on a base substrate and a reflective layer in a first region and a second region.

Referring to FIG. 3A, in some embodiments, the first device side edge of the light-emitting device LD includes a group of a first side edge S1a and a second side edge S1b parallel to each other and extending along the direction D1, and the second device side edge includes a group of a third side edge S2c and a fourth side edge S2d parallel to each other and extending along the direction D2. In some embodiments, the length of the second device side edge in the direction D2 is greater than the length of the first device side edge in the direction D1, but the disclosure is not limited thereto.

The light-emitting device LD has a plurality of top corners formed by included angles between the first device side edge and the second device side edge intersecting with each other. For example, the light-emitting device LD has a first top corner C1, a second top corner C2, a third top corner C3, and a fourth top corner C4. The first top corner C1 is formed by the intersection of the first side edge S1a and the third side edge S2c, the second top corner C2 is formed by the intersection of the second side edge S1b and the third side edge S2c, the third top corner C3 is formed by the intersection of the first side edge S1a and the fourth side edge S2d, and the fourth top corner C4 is formed by the intersection of the second side edge S1b and the fourth side edge S2.

In some embodiments, the reflective layer opening OP1 is defined by both the first reflective layer 109a in the first region R1 and the second reflective layer 109b in the second region R2. For example, the first reflective layer 109a includes a first edge part EP1 close to the light-emitting device LD, the second reflective layer 109b includes a second edge part EP2 close to the light-emitting device LD, and the first edge part EP1 and the second edge part EP2 enclose to form the reflective layer opening OP1, and together constitute the edge part EP of the reflective layer 109. Other portions of the first reflective layer 109a and the second reflective layer 109b other than the first edge part EP1 and the second edge part EP2 are connected to each other and together constitute the body part BP of the reflective layer 109. It should be noted that the outline of the edge part EP of the reflective layer 109 is illustrated by a dotted line in the figure, and the dotted line is only for illustrating the region where the edge part EP is located, and does not indicate that there is an obvious interface between the edge part EP and the body part BP. In some embodiments, the body part BP and the edge part EP are continuous without an obvious interface therebetween. In some other embodiments, depending on the printing path of the 3D printing process when forming the reflective layer, there may be no obvious interface between the first reflective layer 109a and the second reflective layer 109b, or an interface IF may also exist between the first reflective layer 109a and the second reflective layer 109b.

In some embodiments, the reflective layer 109 has a plurality of reflective edges respectively facing a plurality of device side edges of the light-emitting device LD and a plurality of reflective included angles formed by the plurality of reflective edges intersecting with each other. For example, the reflective layer 109 includes a first reflective edge and a second reflective edge respectively facing the first device side edge and the second device side edge of the light-emitting device LD. For example, the first reflective edge includes a first edge RS1a and a second edge RS1b substantially extending along the direction D1, and the second reflective edge includes a third edge RS2c and a fourth edge RS2d substantially extending along the direction D2. The first edge RS1a, the second edge RS1b, the third edge RS2c and the fourth edge RS2d of the reflective layer 109 respectively face the first side edge S1a, the second side edge S1b, the third side edge S2c and the fourth side edge S2d of the light-emitting device LD.

In some embodiments, the first edge RS1a and the second edge RS1b of the first reflective edge of the reflective layer 109 do not extend completely parallel to each other. For example, some portions (for example, the body parts) of the first edge RS1a and the second edge RS1b are parallel to each other and substantially extend along the direction D1, while other portions (for example, the end parts) of the first edge RS1a and the second edge RS1b extend along opposite directions. In some embodiments, the first edge RS1a and the second edge RS1b of the first reflective edge are substantially symmetrical to each other with respect to the centerline CL1 of the light-emitting device LD. In some embodiments, the third edge RS2c and the fourth edge RS2d of the second reflective edge extend substantially parallel to each other along the direction D2. However, the present disclosure is not limited thereto.

In some embodiments, the first edge RS1a, the second edge RS1b, the third edge RS2c, and the fourth edge RS2d of the reflective layer 109 are the reflective edges of the edge part facing the light-emitting device, and enclose to form the reflective layer opening OP1, that is, the reflective layer opening OP1 is defined by the reflective edges of the edge part of the reflective layer. In some embodiments, the first edge RS1a, the second edge RS2c and the fourth edge RS2d are corresponding edges of the first edge part EP1 of the first reflective layer 109a, and the third edge RS is a corresponding side edge of the second edge part EP2 of the second reflective layer 109b. In some embodiments, the side length of the first edge part EP1 is greater than the side length of the second edge part EP2. Herein, the side lengths of the first edge part EP1 and the second edge part EP2 refer to the side lengths of the inner perimeter of the corresponding edge parts in the illustrated plan view, that is, the side length of the first edge part EP1 refers to the sum of the side lengths of the first edge RS1a, the second edge RS1b, and the fourth edge RS2d of the reflective layer 109, and the side length of the second edge part EP2 refers to the side length or length of the third edge RS2c of the reflective layer 109. In other words, most of the edge part EP of the reflective layer 109 is constituted by the edge part EP1 of the first reflective layer. In some embodiments, during the process of forming the first reflective layer and the second reflective layer by 3D printing, the first reflective layer is formed by using a higher-precision printing spray valve. Therefore, most of the edge part EP is constituted by the first edge part, which can improve the accuracy of the reflective layer opening, so that the distances from the respective side edges of the light-emitting device to the reflective layer are substantially equal, thereby improving the light-exiting uniformity and the light-exiting brightness of the light-emitting substrate. Herein, the smaller the difference between the distance from the device side edge of the light-emitting device to the reflective layer and the predetermined distance, the higher the accuracy (e.g., process accuracy, reflective layer opening accuracy, etc.).

The reflective layer 109 has a plurality of included angles formed by the first reflective edge and the second reflective edge intersecting with each other. In some embodiments, the plurality of included angles of the reflective layer 109 may include acute angles, rounded chamfers, or the like. For example, the reflective layer 109 includes a first included angle A1 between the first edge RS1a and the third edge RS2c, a second included angle A2 between the second edge RS1b and the third edge RS2c, a third included angle A3 between the first edge RS1a and the fourth edge RS2d, and a fourth included angle A4 between the second edge RS1b and the fourth edge RS2d. Herein, each edge of the reflective layer defining the opening may be referred to as a reflective edge, and the included angle formed by the intersection of respective reflective edges of the reflective layer may also be referred to as a reflective included angle.

In some embodiments, the distance d1 between the first side edge S1a of the light-emitting device LD and the first edge RS1a of the reflective layer 109 in the direction D2, the distance d2 between the second side edge S1b of the light-emitting device LD and the second edge RS1b of the reflective layer 109 in the direction D2, the distance d3 between the third side edge S2c of the light-emitting device LD and the third edge RS2c of the reflective layer 109 in the direction D1, and the distance d4 between the fourth side edge S2d of the light-emitting device LD and the fourth edge RS2d of the reflective layer 109 in the direction D1 are substantially equal to each other. By the above-mentioned setting of the light-emitting device LD and the reflective layer 109, part of the light emitted from the respective side edges of the light-emitting device LD and reflected by the reflective layer 109 and then exited is reflected in substantially the same manner (for example, the incident angles of the light being incident into the reflective layer, the incident angles of the light being incident into the light- emitting device after being reflected by the reflective layer, and the light-exiting brightness, etc. thereof are substantially the same), such that the light output of the light-emitting device LD is more uniform.

In some embodiments, both the light-emitting device LD and the reflective layer opening OP1 have substantially symmetrical shapes, and are substantially symmetrical with respect to the centerline CL1 of the light-emitting device LD. The angles of the first top corner C1 and the second top corner C2 of the light-emitting device LD are substantially the same, and the angles of the third top corner C3 and the fourth top corner C4 are substantially the same; in some embodiments, angles of the first top corner C1, the second top corner C2, the third top corner C3 and the fourth top corner C4 are all substantially the same as each other, but the present disclosure is not limited thereto. In some embodiments, the first included angle A1 and the second included angle A2 of the reflective layer 109 may be the same type of included angle, and angles of the two included angles may be substantially the same as or different from each other; the third included angle A3 and the fourth included angle A4 may be the same type of included angle, the angles of the two included angles may be substantially the same or different from each other, and angles of the first included angle A1 and the second included angle A2 may be substantially the same as or different from angles of the third included angle A3 and the fourth included angle A4. In this embodiment, angles of the first included angle A1 and the second included angle A2 are different from angles of the third included angle A3 and the fourth included angle A4, for example, the first included angle A1 and the second included angle A2 are acute angles, and the third included angle A3 and the fourth included angle A4 are rounded chamfers. In some embodiments, the first corner-to-corner distance from the first top corner C1 of the light-emitting device LD to the first included angle A1 of the reflective layer 109 is substantially equal to the second corner-to-corner distance from the second top corner C2 of the light-emitting device to the second included angle A2 of the reflective layer 109, and the third corner-to-corner distance between the third top corner C3 of the light-emitting device LD to the third included angle A3 of the reflective layer 109 is substantially equal to the fourth corner-to-corner distance from the fourth top corner C4 of the light-emitting device to the fourth included angle A4 of the reflective layer 109. It should be understood that the above-mentioned corner-to-corner distances being substantially equal includes that these distances are completely equal (that is, each of the them is completely equal to a predetermined distance) or the difference between each of them and the predetermined distance is within a range of 0 to 50 micrometers.

In some embodiments, by setting the light-emitting device and the reflective layer opening in a substantially symmetrical shape, and setting the angles and corresponding corner-to-corner distances of the included angles opposite to each other in the direction D2 to be substantially the same, part of the light emitted from the light-emitting device and reflected by the included angles of the reflective layer and the surrounding regions thereof can be reflected in substantially the same manner, thereby improving the light-exiting uniformity of the light-emitting device, and then improving the light-exiting uniformity of the light-emitting substrate.

In some embodiments, the first edge part EP1 of the first reflective layer 109a and the second edge part EP2 of the second reflective layer 109b have substantially the same thickness, and the thickness of the first edge part EP1 or the second edge part EP2 is less than the thickness of the body part BP. It should be noted that, as described above, the thickness of the edge part EP gradually decreases as being approaching the light-emitting device LD, and has a minimum thickness at a position closest to the light-emitting device LD. Herein, the first edge part EP1 and the second edge part EP2 having substantially the same thickness means that their minimum thicknesses are the same as each other, or their average thicknesses are the same as each other, or that the thicknesses of the respective portions of the edge parts at the same distance from the corresponding reflective edges are the same as each other.

Referring to FIG. 3A, in some embodiments, the plurality of reflective edges RS1a, RS1b, RS2c, and RS2d of the reflective layer 109 each include a body part rb and end parts re1 and re2 at two ends of the body part, and a plurality of reflective included angles of the reflective layer 109 are formed by the end parts of the corresponding reflective edges intersecting with each other. In some embodiments, the extension direction of the end part of at least one of the plurality of reflective edges RS1a, RS1b, RS2c, RS2d of the reflective layer 109 is different from the extension direction of the body part thereof. For example, the body parts rb of the first edge RS1a and the second edge RS1b of the reflective layer 109 extend substantially parallel to each other along the direction D1, while the end parts re1 and re2 of the first edge RS1a or the second edge RS1b each extend along a direction different from the direction D1, the body part rb may be straight, and the end parts re1 and re2 may be curved or inclined. The body parts rb of the third edge RS2c and the fourth edge RS2d of the reflective layer 109 extend substantially parallel to each other along the direction D2, and the end parts re1 and re2 of the third edge RS2c may extend in substantially the same direction D2 as the body part rb thereof, but may also extend in a direction different from the direction D2; for example, the end parts re1 and re2 of the fourth edge RS2d extend in a direction different from the direction D2, and may be provided with a curved surface or an inclined surface .

In some embodiments, the end parts re1 of the first edge RS1a and the second edge RS1b respectively extend from the body parts rb thereof toward a direction away from the extension lines EL1 and EL2 of the body parts rb in the direction D1 and away from the centerline CL1 of the light-emitting device, and may be provided with a curved profile. In other words, the end parts re1 of the first edge RS1a and the second edge RS1b are respectively located on sides of the extension lines EL1 and EL2 of the body parts rb thereof away from the centerline CL1 of the light-emitting device LD. In some embodiments, the end parts re2 of the first edge RS1a and the second edge RS1b respectively extend from the body parts rb thereof toward a direction away from the extension lines EL1 and EL2 of the body parts rb in the direction D1 and close to the centerline CL1 of the light-emitting device LD, and may be provided with a curved profile. In other words, the end parts re2 of the first edge RS1a and the second edge RS1b are respectively located on sides of the extension lines EL1 and EL2 of the body parts rb thereof close to the centerline CL1 of the light-emitting device LD.

In some embodiments, the end parts re1 and re2 of the third edge RS2c may extend substantially along the direction D2; the end parts re1 and re2 of the fourth edge RS2d each extend from the body part rb toward a direction away from the extension line EL4 of the body part rb in the direction D2 and close to the centerline CL2 of the light-emitting device LD, and may be provided with a curved profile, and the centerline CL2 of the light-emitting device LD is a line extending in the direction D2 and passing through the center of the light-emitting device LD. In other words, the end parts re1 and re2 of the fourth edge RS2d are respectively located on a side of the extension line EL4 of the body part rb thereof close to the centerline CL2 of the light-emitting device LD. In some other embodiments, the end parts re1 and re2 of the third edge RS2c may also have a profile similar to that of the fourth edge RS2d, for example, the end parts re1 and re2 of the third edge RS2c may also be located on a side of the extension line EL3 of the body part rb thereof close to the centerline CL2 of the light-emitting device LD.

In some embodiments, each reflective included angle of the reflective layer 109 is formed by end parts of corresponding reflective edges intersecting with each other. For example, the first included angle A1 of the reflective layer 109 is formed by the end parts re1 of the first edge RS1a and the third edge RS2c being intersected with each other; the second included angle A2 of the reflective layer 109 is formed by the end part re1 of the second edge RS1b and the end part re2 of the third edge RS2c being intersected with each other; the third included angle A3 of the reflective layer 109 is formed by the end part re2 of the first edge RS1a and the end part re1 of the fourth edge RS2d being intersected with each other; and the fourth included angle A4 of the reflective layer 109 is formed by the end parts re2 of the second edge RS1b and the end part re2 of the fourth edge RS2d being intersected with each other. In this embodiment, the first included angle A1 and the second included angle A2 of the reflective layer 109 are respectively located on sides of the extension lines EL1 and EL2 of the corresponding body parts of the first edge and the second edge away from the centerline CL1 of the light-emitting device; and the third included angle A3 and the fourth included angle A4 are respectively located on sides of the extension lines EL1 and EL2 of the corresponding body parts of the first edge and the second edge close to the centerline CL1 of the light-emitting device. In other words, the first included angle A1 is located on a side, away from the light-emitting device LD and the centerline CL1 thereof, of an included angle between the extension line EL1 of the body part of the first edge RS1a and the extension line EL3 of the body part of the third edge RS2c; the second included angle A2 is located on a side, away from the light-emitting device LD and the centerline CL1 thereof, of an included angle between the extension line EL2 of the body part of the second edge RS1b and the extension line EL3 of the body part of the third edge RS2c; the third included angle A3 is located on a side, close to the light-emitting device LD (for example, its centerline and top corner C3), of an included angle between the extension line EL1 of the body part of the first edge RS1a and the extension line EL4 of the body part of the fourth edge RS2d; and the fourth included angle A4 is located on a side, close to the light-emitting device LD (for example, its centerline and top corner C4), of an included angle between the extension line EL2 of the body part of the second edge RS1b and the extension line EL4 of the body part of the fourth edge RS2d.

Herein, the types of two or more reflective included angles being the same includes a case in which the shapes and angles of these included angles are completely the same, and also includes a case in which these included angles are located on the same sides of the extension lines of the corresponding reflective edges with respect to the light-emitting device (e.g., the centerline thereof) while the respective shapes, angles, and degrees of curvature may not be completely the same, and have some differences; for example, the first included angle A1 and the second included angle A2 being included angles of the same type includes that the first included angle A1 and the second included angle A2 are respectively located on sides of the extension lines EL1 and EL2 of the corresponding edges away from the centerline of the light-emitting device, the shapes of the first included angle A1 and the second included angle A2 may not be exactly the same, for example, they may both be acute angles or similar acute angles, but the end parts re1 and re2 of the first edge RS1a and the second edge RS1b forming the included angles may have different curvatures; and the third included angle A3 and the fourth included angle A4 being included angles of the same type includes that the third included angle A3 and the fourth included angle A4 are respectively located on sides of the extension lines EL1 and EL2 of the corresponding edges close to the centerline of the light-emitting device, and the shapes of the third included angle A3 and the fourth included angle A4 may not be exactly the same. For example, the third included angle A3 and the fourth included angle A4 may both be rounded chamfers, but the curvatures of the two rounded chamfers may be different. It should be understood that, when viewed from a plan view, "acute angle" refers to an included angle of less than 90° formed by inclined linear end parts, and the included angle may have a sharp top, while "similar acute angle" includes an included angle of less than 90° formed by curved end parts, and the included angle may have a rounded top, such as a rounded chamfer, as illustrated in FIG. 12A and FIG. 12B. Herein, the shapes of two or more included angles being not exactly the same includes having different angles (e.g., having different angles when they both are acute angles), or having different curvatures at the corresponding end parts of the edges that form those included angles.

FIG. 12A and FIG. 12B illustrate physical photos of openings of the reflective layer illustrated in FIG. 3A according to some embodiments of the present disclosure. FIG. 12A and FIG. 12B do not illustrate the light-emitting devices, but combined with the structure illustrated in FIG. 3A, it should be understood that the light-emitting devices are disposed in the reflective layer openings OP1 in FIG. 12A and FIG. 12B. Referring to FIG. 3A, FIG. 12A and FIG. 12B, the first included angle A1 and the second included angle A2 of the reflective layer 109 are included angles of the same type, for example, the first included angle A1 and the second included angle A2 are both located on a side of the extension line of the body part of the corresponding first edge or second edge away from the centerline of the light-emitting device, but the shapes thereof are not completely the same; the third included angle A3 and the fourth included angle A4 are included angles of the same type, that is, the third included angle A3 and the fourth included angle A4 are both located on a side of the extension line of the body part of the corresponding first edge or second edge close to the centerline of the light-emitting device, but the shapes thereof are not completely the same, for example, they may be both rounded chamfers, but with different curvatures.

Herein, a shape or two components being symmetrical or substantially symmetrical about a certain reference line may include the case that the shape or components are completely symmetrical, but also include the case that portions of the shape or components on two sides of the reference line have similar shapes but are not completely symmetrical. For example, the first edge RS1a and the second edge RS1b of the reflective layer 109 being substantially symmetrical with respect to the centerline CL1 of the light-emitting device LD may include the case that the first edge RS1a and the second edge RS1b are completely symmetrical about the centerline CL1 of the light-emitting device, and may also include the case that the first edge RS1a and the second edge RS1b have similar shapes but are not completely symmetrical. For example, as long as it is sufficient to satisfy that the body parts of the first edge and the second edge extend substantially parallel to each other, end parts re1 of the first edge and the second edge are both on the same sides of the extension lines EL1 and EL2 of body parts with respect to the centerline of the light-emitting device, and end parts re2 of the first edge and the second edge are both on the same side of the extension lines EL1 and EL2 of body parts with respect to the centerline of the light-emitting device; the end parts re1 of the first edge and the second edge may both be curves and may have the same or different curvatures, and the end parts re2 of the first edge and the second edge may both be curves and may have the same or different curvatures. That is, end parts, on opposite sides of the centerline of the light-emitting device, of the first edge to the fourth edge of the reflective layer may include curves having different curvatures.

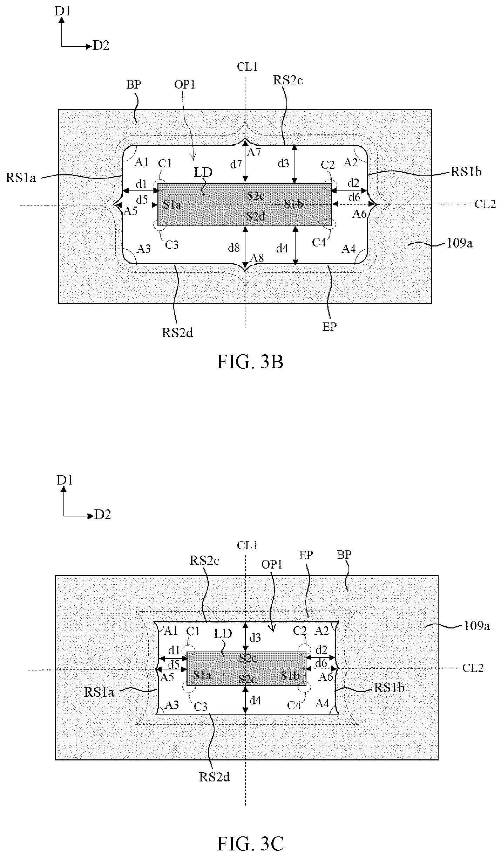

Referring to FIG. 2A and FIG. 3B, in some embodiments, the edge part EP of the reflective layer 109 is completely located in the first reflective layer 109a, and the edge part EP is separated from the second reflective layer 109b by other portions of the first reflective layer 109a. A portion of the first reflective layer 109a located on a side of the edge part EP away from the light-emitting device LD is connected to the second reflective layer 109b and together constitutes the body part BP of the reflective layer 109. That is, the reflective layer opening OP1 is completely defined by the first reflective layer 109a. In some embodiments, the portion (body part) of the first reflective layer 109a located on a side of the edge part EP away from the light-emitting device LD has substantially the same thickness as the second reflective layer 109b, that is, the thickness of the body part of the first reflective layer 109a and the thickness of the body part of the second reflective layer 109b are substantially equal, so that the body part BP of the reflective layer 109 has a substantially uniform thickness, thereby improving the light-exiting uniformity of the light-emitting substrate.

In some embodiments, the shapes of the light-emitting device LD and the reflective layer opening OP1 are each substantially symmetrical with respect to the centerline CL1 of the light-emitting device LD, and also substantially symmetrical with respect to the centerline CL2 of the light-emitting device LD. The centerline CL2 intersects with the centerline CL1 and may be substantially perpendicular to each other. For example, the centerline CL2 extends along the direction D2 and passes through a center point of the light-emitting device LD in the direction D1. In this embodiment, the shapes of the light-emitting device LD and the reflective layer opening OP1 are further arranged to be substantially symmetrical with respect to the centerline CL2, which can further improve the light-exiting uniformity of the light-emitting substrate.

For example, angles of the top corners C1-C4 of the light-emitting device LD are substantially the same as each other, and the included angles A1-A4 of the reflective layer 109 facing the respective top corners C1-C4 are included angles of the same type. For example, the included angles A1-A4 of the reflective layer 109 are all rounded chamfers, and the curvatures of the rounded chamfers may be the same or different. In some embodiments, the corner-to-corner distances from the respective top corners C1-C4 of the light-emitting device LD to the corresponding included angles A1-A4 of the reflective layer 109 may be substantially the same as each other.

In some embodiments, each reflective edge RS1a, RS1b, RS2c, RS2d of the reflective layer 109 includes two sub-edges (e.g., a first sub-edge and a second sub-edge) connected to each other, the reflective layer 109 is provided with a recess, recessed toward the body part of the reflective layer 109 and away from the light-emitting device LD, at the intersection of the two sub-edges, and the recess is an included angle formed by the intersection of the corresponding sub-edges. In some embodiments, the recess of each reflective edge of the reflective layer 109 is aligned with the center point of the corresponding side edge of the light-emitting device. For example, a first sub-edge and a second sub-edge of the first edge RS1a of the reflective layer 109 intersect with each other to form an included angle A5; a first sub-edge and a second sub-edge of the second edge RS1b intersect with each other to form an included angle A6; a first sub-edge and a second sub-edge of the third edge RS2c intersect with each other to form an included angle A7; and a first sub-edge and a second sub-edge of the fourth edge RS2d intersect with each other to form an included angle A8. In some embodiments, the included angle A5 of the first edge RS1a and the included angle A6 of the second edge RS1b are respectively aligned, in the direction D2, with the center points of the first side edge S1a and the second side edge S1b of the light-emitting device LD in the direction D1; the included angles A7 and A8 of the third edge RS2c and the fourth edge RS2d are respectively aligned, in the direction D1, with the center points of the third side edge S2c and the fourth side edge S2b of the light-emitting device LD in the direction D2. In some embodiments, the included angles A5-A8 of the reflective layer 109 are included angles of the same type, such as obtuse angles or similar obtuse angles, and the angles thereof may be substantially the same or different from each other.

In this embodiment, the respective side edges of the light-emitting device LD are at the same distance from the reflective layer at corresponding positions. For example, the distances from positions where the first side edge S1a and the second side edge S1b of the light-emitting device LD are opposite to and aligned to each other in the direction D2 to the corresponding first edge RS1a and the second edge RS1b of the reflective layer 109 in the direction D2 are substantially equal to each other; and the distances from positions where the third side edge S2c and the fourth side edge S2d of the light-emitting device LD are opposite to and aligned to each other in the direction D1 to the corresponding third edge RS2c and the fourth edge RS2d of the reflective layer 109 in the direction D1 are substantially equal to each other. In some embodiments, the distances d1, d2, d3, d4 from the positions of the respective side edges of the light-emitting device LD away from the center points of the side edges and close to the corresponding top corners to the corresponding side edges of the reflective layer 109 are substantially equal to each other, and the distances d5, d6, d7, d8 from the center points of the respective side edges of the light-emitting device LD to the respective included angles A5-A8 (i.e., the intersections of two sub-edges of the respective side edges) of the reflective layer 109 are substantially equal to each other. In some embodiments, the distances d5-d8 are greater than the distances d1-d4. In some embodiments, the distance from a position, near the center point of the side edge, of each side edge of the light-emitting device LD to the corresponding side edge of the reflective layer in the direction D1 or D2 is greater than the distance d1-d4 and less than the distance d5-d8.

In this embodiment, each reflective edge includes a body part and end parts on two ends of the body part, and further includes a recess part in the middle of the body part; the first included angle A1 to the fourth included angle A4 are all of the same type as the included angles A3 and A4 in FIG. 3A, for example, they are all on a side, close to the corresponding centerline of the light-emitting device LD, of the extension line of the body part of the corresponding edge, and on a side, close to the light-emitting device, of the included angle between the extension lines of the body parts of the corresponding edges; while the included angles A5-A8 are all on a side, away from the light-emitting device, of the extension line of the body part of the corresponding edge.

Referring to FIG. 3C, in this embodiment, similar to the embodiment of FIG. 3B, the edge parts EP of the reflective layer 109 are all disposed in the first reflective layer 109a; the light-emitting device LD and the reflective layer opening OP1 are substantially symmetrical with respect to the centerline CL1 of the light-emitting device LD, and are also substantially with respect to the centerline CL2 of the light-emitting device LD, thereby improving the light-exiting uniformity of the light-emitting substrate.

For example, the included angles A1-A4 of the edge part EP of the reflective layer 109 may be included angles of the same type, such as acute angles or similar acute angles, and the angles thereof may be substantially the same or different from each other. The angles of the top corners C1-C4 of the light-emitting device LD are substantially the same, and the distances from the respective top corners C1-C4 of the light-emitting device LD to the corresponding included angles A1-A4 of the reflective layer 109 are substantially the same.

In some embodiments, each of the first edge RS1a and the second edge RS1b of the reflective layer 109 includes two sub-edges (e.g., the first sub-edge and the second sub-edge), and the reflective layer is provided with a recess, recessed toward the reflective layer 109 and away from the light-emitting device LD, at the intersection of the two sub-edges, the recess is an included angle formed by the intersection of the two sub-edges. For example, the first edge RS1a of the reflective layer 109 is provided with an included angle A5 formed by the intersection of two sub-edges, and the second edge RS1b is provided with an included angle A6 formed by the intersection of two sub-edges. In some embodiments, the included angles A5 and A6 of the reflective layer 109 may be included angles of the same type, for example, both are obtuse angles, and the angles thereof may be substantially the same or different from each other, and are aligned with the center points, in the direction D1, of the first edge S1a and the second edge S1b of the light-emitting device LD in the direction D2. In some embodiments, each of the third edge S2c and the fourth edge S2d of the reflective layer 109 extends continuously along the direction D2, and does not include sub-edges intersecting with each other to form a recess, and therefore is not provided with an included angle formed by the intersection of different sub-edges.

In some embodiments, similar to the previous embodiments, the distances d1, d2, d3, d4 from respective side edges of the light-emitting device LD to the reflective layer 109 in the direction D1 or D2 are substantially equal to each other. The distances d5 and d6 from the side edges S1a and S1b of the light-emitting device to the corresponding included angles A5 and A6 of the reflective layer 109 in the direction D2 are equal to each other. In some embodiments, the distances d5 and d6 are greater than the distances d1-d4.

In this embodiment, the respective reflective included angles A1-A4 of the reflective layer 109 are all included angles of the same type as the reflective included angles A1-A2 in FIG. 3A. For example, the reflective included angles A1-A4 are all respectively located on sides, away from the centerline CL1 of the light-emitting device, of the extension lines of the body parts of the first edge RS1a and the second edge RS1b, and on sides, away from the light-emitting device, of the included angle between the extension lines of the body parts of the corresponding edges. The reflective included angles A5 and A6 are respectively located on sides, away from the light-emitting device, of the extension lines of the body parts of the first edge RS1a and the second edge RS1b.

Referring to FIG. 3D, this embodiment is similar to the embodiment illustrated in FIG. 3B, the difference lies in that, in this embodiment, the respective reflective edges RS1a, RS1b, RS2a, RS2b of the reflective layer 109 are all free of a recess. The distances from respective reflective edges of the reflective layer 109 to the reflective layer are substantially the same, and the distances from respective top corners of the light-emitting device LD to the corresponding included angles of the reflective layer are also substantially the same. Other features of the structure illustrated in FIG. 3D are substantially the same as those of the embodiment illustrated in FIG. 3B, and will not be repeated here.

FIG. 3A to FIG. 3D illustrate various embodiments of reflective layer openings. It should be understood that the reflective layer of the light-emitting substrate may adopt any of the reflective layer openings of the above-mentioned embodiments, and in a reflective layer of the same light-emitting substrate, the shapes of the plurality of reflective layer openings are substantially the same. For example, the shapes of the plurality of reflective layer openings may all be selected from the same one type of the above-mentioned embodiments to make the light-emitting brightness of the plurality of light-emitting devices substantially the same, thereby avoiding defects such as optical bright and dark strips or mura, and further improving the light-exiting uniformity of the light-emitting substrate.

FIG. 3E illustrates a schematic cross-sectional view taken along a line B-B' of FIG. 2A according to some embodiments of the present disclosure. It should be understood that, for the sake of simplicity, only the light-emitting substrate 100, the reflective layer 109 and the light-emitting device LD are illustrated in FIG. 3E, and other components of the light-emitting substrate can refer to FIG. 2B.

Referring to FIG. 2A and FIG. 3E, in some embodiments, the reflective layer 109a in the first region R1 and the reflective layer 109b in the second region R2 are connected to each other to form a continuous reflective layer 109 with substantially uniform thickness. In some embodiments, the edge part EP of the reflective layer 109 is a portion of the reflective layer 109a close to the light-emitting device LD, and a portion of the reflective layer 109a on a side of the edge part EP away from the light-emitting device LD and the reflective layer 109b together constitute the body part BP of the reflective layer 109. In some embodiments, there is an obvious interface IF1 at the junction of the reflective layer 109a and the reflective layer 109b, but there may also be no obvious interface. Alternatively, in some embodiments, there is an interface at part of the junction of the reflective layers 109a and 109b, while there may be free of interface at other part of the junction of the reflective layers 109a and 109b.

In some embodiments, the reflective layer 109b includes a plurality of overlapping portions. For example, the reflective layer 109b includes a plurality of reflective strips P1 and P2; the plurality of reflective strips P1 extend parallel to each other along the direction D2 and are spaced apart from each other in the direction D1, that is, there is a gap between adjacent reflective strips P1. In some embodiments, the reflective strip P2 extends along the direction D2 and fill the gap between adjacent reflective strips P1. The reflective strip P2 is located between two adjacent reflective strips P1, and overlaps with the two adjacent reflective strips P1 in the direction D3 perpendicular to the main surface of the base substrate 100. In some embodiments, there is an interface IF2 between adjacent reflective strips P1 and P2, but the present disclosure is not limited thereto. In some other embodiments, the reflective layer 109b is a whole layer of reflective material formed by a plurality of reflective strips being merged with each other, and there may be free of interface IF2 illustrated in FIG. 3E.

In some embodiments, one or more reflective strips P2 are further filled in the gap between the reflective strip P1 and the reflective layer 109a, and overlapped with the reflective layer 109a in the direction perpendicular to the main surface of the base substrate 100. There may be an interface between the reflective strip P2 and the reflective layer 109a that are adjacent to each other. However, the present disclosure is not limited thereto. In some other embodiments, the reflective strip(s) P2 is/are only disposed between adjacent reflective strips P1 to fill the gap between the reflective strips P1; moreover, there is no gap between the reflective strip P1 in the second region R2 close to the first region and the reflective layer 109a, and the reflective strip P1 and the reflective layer 109a are connected to each other and overlap with each other in a direction perpendicular to the main surface of the base substrate 100.

In the embodiments of the present disclosure, by setting the reflective layer to include a plurality of reflective strips overlapping with each other, the adhesion of the reflective layer to the surface of the substrate (for example, the surface of the material layer above the base substrate directly in contact with the reflective layer) can be improved, thereby improving the thickness uniformity and reliability of the reflective layer.

FIG. 4A illustrates a schematic plan view of print heads corresponding to various regions of the light-emitting substrate in a 3D printing process after bonding light-emitting devices LD and/or other additional devices AD on the light-emitting substrate according to some embodiments of the present disclosure. It should be understood that the figure only schematically illustrates the relevant dimensions of the print head and the components on the light-emitting substrate, these dimensions are not drawn to scale, and the position of the print head and its relative position to the light-emitting substrate illustrated in the figure does not represent its position during the actual printing process. FIG. 4B is a schematic cross-sectional view of printing a reflective layer by a print head over a base substrate. It should be understood that, for the sake of brevity, respective material layers above the base substrate 100 are not specifically illustrated in FIG. 4B.

Referring to FIG. 2A and FIG. 4A, in some embodiments, after the light-emitting device LD is bonded to the base substrate 100 by, for example, a soldering process, the reflective layer 109 is formed around the light-emitting device LD using a 3D printing device with a 3D printing technique. For example, in the 3D printing process, the reflective material is sprayed on the base substrate by using a print head, and then the reflective material is subjected to processes such as leveling and thermal curing, so as to form the reflective layer. In some embodiments, the reflective material is printed using a pneumatic print head, but the present disclosure is not limited thereto. In some embodiments, the print head may include one or more spray valves. During the printing process, as illustrated in FIG. 4B, the reflective material 109' is ejected from the print head 161/162 in shape of strip, and the reflective material 109' forms a reflective strip above the base substrate 100 as the print head 161/162 travels along a predetermined printing path (for example, along a direction Dx). In some embodiments, the reflective strips printed in adjacent printing paths are connected or overlapped with each other, and merged with each other to form the reflective layer. In some embodiments, there may have or may not have an obvious interface between adjacent reflective strips depending on the time interval that the reflective strips are ejected from the print head. For example, when the time interval between printing adjacent reflective strips (that is, the interval between the times at which adjacent reflective strips are ejected by the print head) is short, there may be no obvious interface between adjacent reflective strips; when the time interval between printing adjacent reflective strips is long, there may be an obvious interface between adjacent reflective strips.

Still referring to FIG. 4A, in some embodiments, the first region R1 where the light-emitting device LD is located is referred to as a first printing region, that is, the first printing region extends along the direction D2 and extends across a plurality of light-emitting devices LD; and the second region R2 between the first regions R1 in the direction D1 is referred to as a second printing region. In some embodiments, the reflective material is printed in the first printing region to form the reflective layer 109a illustrated in FIG. 2A, and the reflective material is printed in the second printing region to form the reflective layer 109b illustrated in FIG. 2A.

In some embodiments, the same or different print heads may be used to print reflective material in the first printing region and the second printing region. For example, the print head 151 and the print head 152 may be used to print reflective material in the first printing region and the second printing region, respectively. Printing the reflective material in the first printing region and printing the reflective material in the second printing region may be performed sequentially or simultaneously. In some embodiments, different print heads are used to print the reflective material in the first printing region and the second printing region, for example, the first print head and the second print head are used to print the first reflective material layer and the second reflective material layer in the first printing region and the second printing region, respectively; the first print head and the second print head can simultaneously or sequentially print reflective material in their respective printing regions according to predetermined printing paths. In some embodiments, after the first print head travels along a predetermined printing path in the first printing region for a certain distance, the second print head starts to travel along a predetermined printing path in the second printing region. However, the present disclosure is not limited thereto.

In some embodiments, each print head may include one or more spray valves, and a plurality of spray valves may simultaneously print in one or more first printing regions or one or more second printing regions. For example, the print head 151 may include a plurality of spray valves 161, and the plurality of spray valves 161 are arranged, for example, along the direction D1 and spaced apart from each other. The print head 152 may include a plurality of spray valves 162, and the plurality of spray valves 162 are arranged, for example, along the direction D1 and spaced apart from each other. In some embodiments, in the same first printing region, a plurality of light-emitting devices LD are arranged in a row along the direction D2, and in different first printing regions, a plurality of light-emitting devices LD are aligned and arranged in a column along the direction D1. In some embodiments, during the 3D printing process, the reflective material in each first printing region is printed by one spray valve 161, and the reflective material in each second printing region is printed by one spray valve 162, but the disclosure is not limited thereto; the plurality of spray valves 161 of the print head 151 can simultaneously print reflective materials in a plurality of first printing regions along the same printing path; and the plurality of spray valves 162 of the printing head 152 can simultaneously print reflective materials in a plurality of second printing regions along the same printing path.

In some embodiments, in the direction D1, adjacent light-emitting devices LD are separated by a pitch P1; in the print head 151, adjacent spray valves 161 are separated by a pitch P2; and in the print head 152, adjacent spray valves 162 are separated by a pitch P3. Herein, "pitch" refers to the distance between center points of two adjacent components. In some embodiments, the pitch P2 between adjacent spray valves 161 of the plurality of spray valves 161 in the print head 151 may be an integer multiple (for example, 1, 2, 3...) of the pitch P1 of the light-emitting devices LD; that is, the pitch P2 of the spray valves 161 may be equal to the pitch P1 of the light-emitting devices LD, or greater than the pitch P1 of the light-emitting devices LD and may be an integer multiple of two or more times the pitch P1. The above-mentioned pitch settings of the light-emitting devices LD and the spray valves 161 can enable the plurality of spray valves 161 to simultaneously print reflective materials in a plurality of first printing regions (e.g., two first printing regions adjacent to each other or two first printing regions with one or more other first printing regions interposed therebetween), thereby improving the printing efficiency. It should be understood that two first printing regions adjacent to each other indicates that only one or more second printing regions are interposed therebetween and no other first printing region is interposed therebetween.

In some embodiments, the pitch P3 between adjacent spray valves 162 of the plurality of spray valves 162 in the print head 152 may be an integer multiple (for example, 1, 2, 3...) of the pitch of the light-emitting devices LD; that is, the pitch P3 of the spray valves 162 may be equal to the pitch P1 of the light-emitting devices LD, or greater than the pitch P1 of the light-emitting devices LD and be an integer multiple of (such as two or more times) the pitch P1. In this embodiment, because the second printing region is between adjacent first printing regions, the pitch between adjacent second printing regions is substantially equal to the pitch P1 between adjacent light-emitting devices. Therefore, the above-mentioned pitch setting of the spray valves 162 can enable the plurality of spray valves 162 to simultaneously print reflective materials in a plurality of second printing regions (e.g., two second printing regions adjacent to each other or two second printing regions with one or more other second printing regions interposed therebetween), thereby improving the printing efficiency.

In some embodiments, the dimensions (e.g., diameter, width, area, etc.) of the spray valves 161 and 162 of the print heads 151 and 152 may be different. In some embodiments, spray valves with smaller dimensions may print with relatively higher accuracy, while spray valves with larger dimensions may print with relatively higher speed. For example, the dimension of the spray valve 161 of the print head 151 is smaller than the dimension of the spray valve 162 of the print head 152. In the first printing region with the light-emitting device 162 disposed therein, the spray valve 161 with a smaller dimension is used to print the reflective material, which has higher precision, and can better control the dimension and position of the reflective layer opening, so that the gap distance between the light-emitting device and the reflective layer is substantially equal to a predetermined distance, and the distances from respective side edges of the light-emitting device to the reflective layer are substantially equal, thereby improving the light-exiting uniformity of the light-emitting substrate. Moreover, the reflective layer is formed after bonding the light-emitting device, through which the predetermined gap distance can be set to be relatively low, thereby increasing the area of the reflective layer, improving the light utilization efficiency of the light-emitting device, and further improving the light efficiency of the light-emitting substrate.

In the second printing region without the light-emitting device 162 (that is, at least part of the formed reflective layer does not have a reflective layer opening), the spray valve 162 with a larger dimension is used to print reflective material, which can improve the printing efficiency. In some embodiments, although the dimensions (e.g., width, thickness, etc.) of the reflective strips ejected by spray valves of different dimensions may be different, the printing paths in different printing regions and the overlapping dimension of adjacent printing paths can be adjusted so that the thickness of a portion of the reflective layer 109a finally formed in the first printing region except for the edge part is substantially the same as the thickness of the reflective layer 109b finally formed in the second printing region, so that the body part BP of the reflective layer 109 has a substantially uniform thickness.

Still referring to FIG. 4A, in some embodiments, before performing the 3D printing process, in addition to bonding the light-emitting devices LD, one or more additional devices AD may be further bonded to the conductive pads above the base substrate. The additional device AD may be, for example, a driver chip for driving the light-emitting device to emit light and/or other types of devices. The dimension, shape, etc. of the additional device AD may be the same as or different from that of the light-emitting device LD. For example, the additional device AD is located in a sub-region R3 of the second region R2 and is spaced apart from the light-emitting device LD. In some embodiments, in the sub-region R3, the reflective layer is also provided with an opening, and the additional device AD is located in the reflective layer opening of the sub-region R3 and spaced apart from the reflective layer. In some embodiments, a plurality of additional devices AD of the same type may be arranged in rows or columns or arrays in one or more sub-regions R3. The sub-region R3 may extend along the direction D2, and one additional device AD or a plurality of additional devices AD arranged in a row along the direction D2 may be disposed therein; and the additional devices AD in different sub-regions R3 may be aligned with each other and arranged in a column in the direction D1.

In some embodiments, the sub-region R3 of the second region R2 corresponds to a third printing region, because reflective layer opening(s) need to be formed in the third printing region, a print head (for example, the print head 151 or other print head with a spray valve having a smaller dimension) with a spray valve of a smaller dimension (higher accuracy) may be used to print the reflective material in the third printing region. That is to say, in the second printing region provided with the additional device AD, spray valves with two types of dimensions can be used for printing, that is, in the sub-region R3, a spray valve with a smaller dimension is used to improve the printing accuracy, and the dimension and position of the reflective layer opening can be better controlled; while in other regions other than the sub-region R3, a spray valve with a larger dimension is used to improve the printing efficiency.

In some embodiments, the pitch P4 of adjacent additional devices AD in the direction D1 may be an integer multiple (for example, 1, 2, 3...) of the pitch P1 of the light-emitting devices LD, and the pitch between adjacent spray valves in the print head used for printing in the sub-region R3 may be an integer multiple (for example, 1, 2, 3...) of the pitch P4, so that a plurality of spray valves of the print head can simultaneously print reflective material in a plurality of sub-regions R3 to improve printing efficiency. In some embodiments, through setting the pitch P4 of the additional devices AD to be an integer multiple of the pitch of the light-emitting devices, the first printing region and the third printing region can use the same or similar print heads.

FIG. 5A schematically illustrates a schematic diagram of a printing path for forming a reflective layer by a 3D printing process. It should be understood that the printing path in the respective regions are illustrated by lines in the figure, and the line represents the travel path of the print head, but does not represent the width of the ejected reflective strip.

Referring to FIG. 5A, in some embodiments, in the first printing region R1' where the first row of light-emitting devices LD are located, each spray valve of the print head (for example, the print head 151 in FIG. 4A) starts to print the reflective material from a printing start point SP1, and travels along the path illustrated in the figure at a substantially uniform speed until reaching a printing end point EP1 to complete the printing of the reflective material in the first printing region R1'. Similarly, in the second printing region R2' immediately adjacent to the first printing region R1' mentioned above, each spray valve of the print head (for example, the print head 152 in FIG. 4A) starts to print the reflective material from a printing start point SP2, and travels along the path illustrated in the figure at a substantially uniform speed until reaching a printing end point EP2 to complete the printing of the reflective material in the second printing region R2'; in the first printing region R1' where the second row of light-emitting devices LD are located in the figure, the print head travels from the printing start point SP3 to the printing end point EP3 to complete the printing of the reflective material in this first printing region R1'; in the second printing region R2' immediately adjacent to the first printing region R1' where the second row of light-emitting devices LD are located, because an additional device AD is disposed, a plurality of printing paths using different print heads may be included, for example, the print head 152 travels from the printing start point SP4 to the printing end point EP4 to complete the printing of part of the reflective material in the second printing region R2'; a print head (for example, the print head 151) with a spray valve of a smaller dimension is used to travel from the printing start point SP5 to the printing end point EP5 to complete the printing of the reflective material in the sub-region R3 in this second printing region R2'; and the print head 152 travels from the printing start point SP6 to the printing end point EP6 to complete the printing of the remaining reflective material in this second printing region R2'. It should be understood that the printing paths illustrated in FIG. 5A are only for illustration, and the present disclosure is not limited thereto. In some embodiments, the printing region illustrated in FIG. 5A may be referred to as a printing unit, and a plurality of printing units identical to the printing unit illustrated in FIG. 5A may be included above and/or below the printing region illustrated in FIG. 5A in the direction D1, that is, a plurality of repetitive printing units are arranged in the direction D1 above the base substrate, each printing unit may perform printing in accordance with the printing path illustrated in FIG. 5A, and a plurality of spray valves of the print head may simultaneously print reflective material in the plurality of printing units along the same printing path.

FIG. 5B illustrates a schematic enlarged view of printing paths in the first printing region R1' and the second printing region R2'.

In some embodiments, during the 3D printing process, the spray valve of the print head prints a plurality of reflective strips in each region according to a predetermined printing path, and the plurality of reflective strips are merged together to form a reflective layer. For example, in the first printing region R1', the spray valve 161 (FIG. 4A) of the print head 151 sprays a plurality of reflective strips in a strip form starting from the printing start point SP1 and along the printing path illustrated in the figure. The printing path (or may be referred to as a first printing path) includes a plurality of sub-paths adjacent to each other, each sub-path prints to form a reflective strip, and a plurality of reflective strips formed by the plurality of sub-paths are merged with each other to form a reflective layer. In some embodiments, the first printing region R1' extends along the direction D2, and the width of the first printing region R1' in the direction D2 may be greater than the width thereof in the direction D1. In some embodiments, the first printing region R1' may include a sub-printing region r1 surrounding the light-emitting device and a sub-printing region r2 located on a side of the sub-printing region r1 away from the light-emitting device. In the sub-printing region r1, the printing path may be ring-shaped (for example, open ring-shaped), so that reflective strips surrounding at least part of the side edges of the light-emitting device can be printed and formed; in the sub-printing region r2, a plurality of sub-paths substantially extend along the direction D2, and the print head can travel in opposite directions in two adjacent sub-paths along the direction D2.

For example, the spray valve 161 of the print head sprays reflective material in a strip form starting from the printing start point SP1, and traveling (for example, at a constant speed) along the sub-path pa1 in the direction D2 and forms a sub-reflective strip 108a1, and upon traveling to a position close to the light-emitting device LD (i.e., close to the sub-region r1 surrounding the light-emitting device LD), the print head travels a predetermined distance dy1 along the direction D1, and then proceeds to travel along the sub-path pa2 in the direction D2 and forms the sub-reflective strip 108a2; the sub-path pa2 and the sub-path pa1 are in opposite directions so that the sub-reflective strips 108a1 and 108a2 are connected to each other; thereafter, when traveling to a position aligned with the printing start point SP2 in the direction D1, the print head travels a predetermined distance dy1 along the direction D1, and then travels along the sub-path pa3 in the direction D2 to a position at the sub-region r1 close to the light-emitting device LD (for example, close to a first top corner of the light-emitting device LD). In some embodiments, when the print head moves the predetermined distance dy1 along the direction D1, the spray valve may be in an open state. The distance dy1 or dy2 may also be referred to as an offset distance, and is substantially equal to the offset distance of the centers of adjacent sub-reflective strips in the direction D1.

Thereafter, the print head 151 changes the traveling direction, and prints a reflective strip (or may be referred to as an edge reflective strip) along the periphery of the light-emitting device at a position spaced apart from the light-emitting device by a predetermined distance, thereby bypassing the light-emitting device LD, and printing an edge reflective strip for defining the reflective layer opening around the light-emitting device LD. In some embodiments, the edge reflective strip may be in the shape of a ring, such as an open ring, but may also be a closed ring. For example, in the sub-region r1, the print head firstly travels in the direction D1 along a path substantially parallel to the first side edge of the light-emitting device by a certain distance (for example, a distance greater than the length of the first side edge), then travels in the direction D2 along a path substantially parallel to the fourth side edge of the light-emitting device LD by a certain distance (for example, a distance greater than the length of the fourth side edge), and then travels in the direction D1 along a path substantially parallel to the second side edge by a certain distance (for example, a distance greater than the length of the second side edge) to arrive at a position close to the second top corner of the light-emitting device LD. In this way, a ring-shaped edge reflective strip surrounding the light-emitting device LD is formed. In this embodiment, the edge reflective strip formed by the print head 151 in the first printing region is in a shape of open ring and surrounds part of the side edges (for example, three side edges) of the light-emitting device LD, and the edge reflective strip formed by the print head 151 and a portion of the reflective strip formed in the upper adjacent second printing region will enclose to form the reflective layer opening.

Still referring to FIG. 5B, after printing and forming the edge reflective strip in the sub-region r1, the print head moves along the direction D2 by a certain distance and then travels along the direction D1 to a position aligned with the sub-path pa1 in the direction D2. Afterwards, the print head travels in substantially the same paths as the above-mentioned sub-regions r2 and r1 to complete the printing of the reflective material in the entire first printing region R1'.

In some embodiments, in the second printing region R2' without the reflective layer opening, the printing path of the print head 152 may include traveling from the printing start point SP2 along the sub-path pb1 in the direction D2 by a predetermined distance (for example, a distance substantially equal to the width of the reflective layer in the direction D2), then the print head 152 moves along the direction D1 by a predetermined distance dy2, and then travels along the sub-path Pb2 in the direction D2 to a position aligned with the printing start point SP2 in the direction D1; the sub-path pb2 is in the opposite direction to the sub-path pb1 so that the sub-reflective strips printed by the two adjacent sub-paths are connected to each other; after which the printing path similar to the above path is repeated to complete the printing of the reflective material in the second printing region R2'. In some embodiments, in the printing path of the print head 152, the sub-path along the direction D2 may also be referred to as a primary path, and the sub-path moving along the direction D1 by the predetermined distance dy2 may also be referred to as a secondary path.

In other words, the printing path of the print head 152 includes a plurality of primary paths along the direction D2 and secondary path(s) along the direction D1, the plurality of primary paths are arranged along the direction D1, and are connected to each other through the secondary path(s), the traveling directions of the print head on two adjacent primary paths are opposite to each other, and the traveling directions of the print head on a plurality of secondary paths are consistent. In some embodiments, the above-mentioned printing path of the print head 152 may also be referred to as a printing path similar to the shape of the Chinese character " 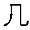 ".

As mentioned above, the print head prints the reflective strip in the form of a strip, and the sub-reflective strips printed by the print head along respective sub-paths are connected or overlapped with each other, so as to be merged with each other to form the reflective layer. In some embodiments, the dimension of the print head varies, and the amount of the reflective material ejected from the print heads may vary, which in turn causes the dimensions (e.g., width, thickness, etc., in a direction perpendicular to its extension direction) of the printed sub-reflective strips to vary as well. For example, the width w1 in the direction D1 of the sub-reflective strip 108a1 or 108a2 printed by the print head 151 with a smaller dimension on a single sub-path in the first printing region R1' is less than the width w2 in the direction D1 of the sub-reflective strip 108b1 or 108b2 printed by the print head 152 with a larger dimension on a single sub-path in the second printing region R2'. Moreover, the thickness of a single sub-reflective strip 108a1 or 108a2 in the direction perpendicular to the main surface of the base substrate (that is, the direction perpendicular to the paper in FIG. 5B) may be less than the thickness of a single sub-reflective strip 108b1 or 108b2 in the direction perpendicular to the main surface of the base substrate.

In some embodiments, in order to make the thicknesses of the reflective layers formed in the first printing region and the second printing region (that is, the reflective layers formed by the respective sub-reflective strips being merged with each other) substantially the same as each other, the distance that the print head moves on the secondary path between adjacent primary paths in the first printing region is set to be less than the distance that the print head moves on the secondary path between adjacent primary paths in the second printing region, so that the dimension (for example, the width in a direction perpendicular to the extension direction of the respective sub-reflective strips) of the region where adjacent sub-reflective strips overlap with each other in the first printing region is greater than the dimension of the region where adjacent sub-reflective strips overlap with each other in the second printing region, through which the thickness of the reflective layer formed by the sub-reflective strips in the first printing region being merged with each other is substantially equal to the thickness of the reflective layer formed by the sub-reflective strips in the second printing region being merged with each other, thereby improving the light-exiting uniformity of the light-emitting substrate. It should be understood that, the distance that the print head moves on the secondary path between adjacent primary paths is substantially equal to the distance between the centers of adjacent sub-reflective strips, that is, the pitch; the smaller the pitch between adjacent sub-reflective strips, the relatively larger the overlapping dimension between adjacent reflective strips, which facilitate increasing the thickness of the reflective layer after the sub-reflective strips are merged (that is, the thickness increment of the sub-reflective strips after being merged is relatively large); accordingly, the larger the pitch between adjacent sub-reflective strips, the smaller the overlapping dimension between adjacent reflective strips, and the relatively smaller the thickness increment of the sub-reflective strips after being merged. In other words, the pitch between adjacent sub-reflective strips is substantially inversely proportional to the overlapping dimension thereof.

For example, in the first printing region R1', the sub-reflective strips 108a1 and 108a2 are adjacent to each other in the direction D1, and the pitch between the center of the sub-reflective strip 108a1 and the center of the sub-reflective strip 108a2 is substantially equal to the distance dy1 that the print head moves along the secondary path in the direction D1; the sub-reflective strips 108a1 and 108a2 overlap with each other in a direction perpendicular to the base substrate, and have an overlapping width od1 along the direction D1; it should be understood that the overlapping width between the sub-reflective strips refers to the width of the overlapping region of the two sub-reflective strips in a direction perpendicular to the extension direction (e.g., direction D2) of the sub-reflective strips, that is, in the width direction (e.g., direction D1) of the sub-reflective strips. Similarly, in the second printing region R2', the sub-reflective strips 108b1 and 108b2 are adjacent to each other in the direction D1, and the pitch between the center of the sub-reflective strip 108b1 and the center of the sub-reflective strip 108b2 is substantially equal to the distance dy2 that the print head moves along the secondary path in the direction D1; the sub-reflective strips 108b1 and 108b2 overlap with each other in a direction perpendicular to the base substrate, and have an overlapping width od2 along the direction D1. In some embodiments, the distance dy1 that the print head moves along the secondary path in the first printing path is less than the distance dy2 that the print head moves along the secondary path in the second printing path, so that the overlapping width od1 of the sub-reflective strips 108a1 and 108a2 is greater than the overlapping width of the sub-reflective strips 108b1 and 108b2, so that the thickness increment of the sub-reflective strips 108a1 and 108a2 after being merged is greater than the thickness increment of the sub-reflective strips 108b1 and 108b2 after being merged, thereby compensating for the difference in thickness between the sub-reflective strips 108a1/108a2 and the sub-reflective strips 108b1/108b2, so that the thickness of the body part of the reflective layer 109a formed by a plurality of sub-reflective strips in the first printing region being merged with each other is substantially equal to the thickness of the body part of the reflective layer 109b formed by a plurality of sub-reflective strips in the second printing region being merged with each other, thereby improving the thickness uniformity of the reflective layer, and improving the light-exiting uniformity of the light-emitting substrate.

FIG. 5C illustrates a schematic view of an enlarged path of the region 112 in the printing path illustrated in FIG. 5A according to some embodiments.

Referring to FIG. 5A to FIG. 5C, as described above with reference to FIG. 5B, in the first printing region, the print head prints the reflective material around the periphery of the light-emitting device LD along the first printing path at a position close to the light-emitting device LD and spaced apart a certain distance from the light-emitting device LD, and forms an edge reflective strip EP1' surrounding the light-emitting device LD. In this embodiment, the edge reflective strip EP1' is a continuous sub-reflective strip formed by printing along a continuous sub-path. The edge reflective strip EP1' may surround part of the side edges of the light-emitting device LD, while the other one side edge or other side edges of the light-emitting device LD are not surrounded by the edge reflective strip EP1'. In the second printing region, the print head prints the reflective material along the second printing path (for example, the above-mentioned printing path similar to the shape of the Chinese character " 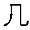 "). In this embodiment, at a position in the second printing region close to the first printing region, the print head prints along the side edge(s) of the light-emitting device LD that is not surrounded by the edge reflective strip EP1' at a position close to the light-emitting device to form an edge reflective strip, and the edge reflective strip and the edge reflective strip EP1' enclose to form the reflective layer opening OP1.

For example, a side edge of the light-emitting device that is close to the second printing region and extending along the direction D2 is not surrounded by the edge reflective strip EP1', and the primary path of the print head in the second printing region extends along the direction D2, and a portion of a sub-reflective strip that is printed along a primary path in the second printing region and is close to the first printing region is served as the edge reflective strip EP2', and the edge reflective strip EP2' and the edge reflective strip EP1' are connected to each other and enclose to form the reflective layer opening OP1. The reflective layer formed according to this printing path is illustrated in FIG. 3A, and the structural features thereof will not be repeated here. It should be understood that FIG. 5C only schematically illustrates the printing path of the edge reflective strips, and for the sake of clarity and brevity of the drawings, the case where the edge reflective strip overlaps with other sub-reflective strips are not illustrated, and the widths of the reflective strips, etc., are not illustrated to scale.

FIG. 6A to FIG. 8A respectively illustrate schematic views of printing paths in the first printing region according to other embodiments of the present disclosure, and FIG. 6B to FIG. 8B respectively illustrate schematic enlarged views of printing paths in the region 113 in FIG. 6A to FIG. 8A. Parts of the reflective layers formed according to the printing paths illustrated in FIG. 6A, FIG. 7A, and FIG. 8A are illustrated in FIG. 3B, FIG. 3C, and FIG. 3D, respectively.

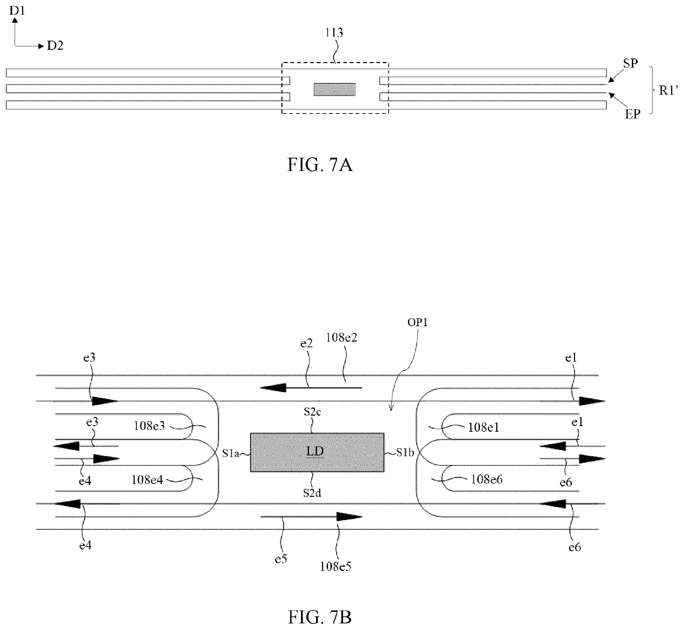

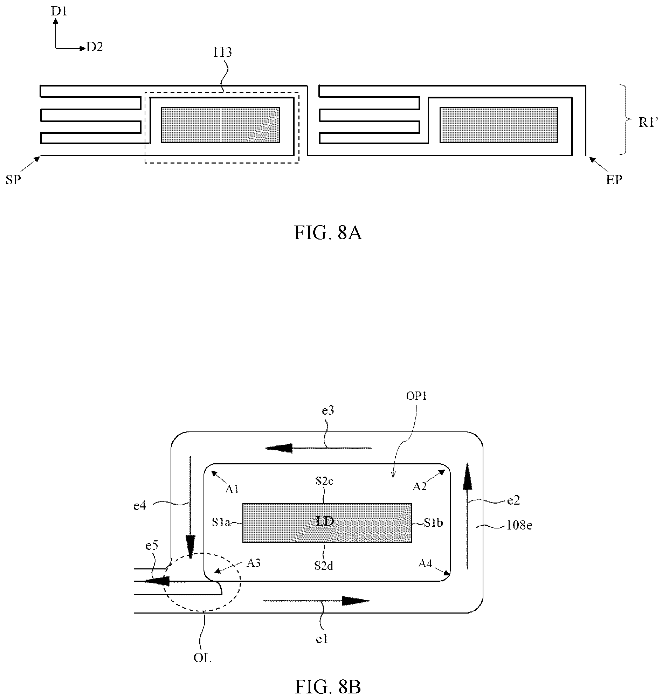

In the embodiments illustrated in FIG. 6A to FIG. 8A, similar to the previous embodiments, in the first printing region R1', the spray valve of the print head travels along the sub-path from the printing start point SP to a position close to the light-emitting device, then the travel direction thereof is changed, and the spray valve prints an edge reflective material layer around the periphery of the light-emitting device to bypass the light-emitting device and enclose to form the reflective layer opening. Different from the previous embodiments, in these embodiments, the edge reflective material layer in the first printing region completely surrounds the light-emitting device and defines the reflective layer opening, without being enclosed with the sub-reflective strips in the second region to form the reflective layer opening; in addition, the edge reflective material layer may be formed by connecting a plurality of edge sub-reflective strips printed along a plurality of sub-paths, and the plurality of edge sub-reflective strips enclose to form the reflective layer opening (for example, as illustrated in the embodiments of FIG. 6A and FIG. 7A); alternatively, the edge reflective material layer may be a single ring-shaped edge reflective strip printed and formed along an ring-shaped sub-path around the periphery of the light-emitting device (e.g., as illustrated in the embodiment of FIG. 8A). It should be understood that, a portion of the edge reflective material layer close to the light-emitting device LD constitutes the edge part EP of the reflective layer illustrated in FIG. 3B-FIG. 3D, and the reflective edges of the edge part EP facing the light-emitting device and the included angles between respective reflective edges are the corresponding edges and included angles of the edge reflective material layer facing the light-emitting device. In these embodiments, the printing path in the second printing region may be similar to that of the previous embodiments.

Referring to FIG. 6A and FIG. 6B, for example, in some embodiments, the print head travels from the printing starting point SP along the direction D2 to a position close to the side edge S1b of the light-emitting device LD (for example, close to the center point of the side edge S1b in the direction D1), then changes the travel direction thereof, and print an edge sub-reflective strip 108e1 along an edge sub-path, and the edge sub-reflective strip 108e1 may surround part of the side edge of the light-emitting device LD, for example, may surround a portion of the side edge S1b and a portion of the side edge S2c. For example, printing the edge sub-reflective strip 108e1 along the edge sub-path may include the follows: the print head travels along the direction D1 parallel to the side edge S1b of the light-emitting device for a certain distance, and then travels along the direction D2 parallel to the side edge S2c of the light-emitting device to a position close to the center point of the side edge S2c; then changes the travel direction thereof and travels along the direction D1 and other sub-paths to complete the printing of other sub-paths; thereafter, the print head travels from other sub-paths to a position close to the center point of the side edge S2c, and print an edge sub-reflective strip 108e2 along an edge sub-path, and the edge sub-reflective strip 108e2 may surround part of the side edges of the light-emitting device LD, for example, may surround a portion of the side edge S2c and a portion of the side edge S1a. For example, printing the edge sub-reflective strip 108e2 along the edge sub-path may include the follows: the print head travels along the direction D2 parallel to the side edge S2c of the light-emitting device for a certain distance, and then travels along the direction D1 parallel to the side edge S1a of the light-emitting device to a position close to the center point of the side edge S1a, and changes the travel direction thereof to travel along the direction D1 and other sub-paths.

Next, the print head travels from other sub-paths to a position close to the center point of the side edge S1a, and prints an edge sub-reflective strip 108e3 along an edge sub-path, and the edge sub-reflective strip 108e3 may surround part of the side edges of the light-emitting device LD, for example, may surround a portion of the side edge S1a and a portion of the side edge S2d. For example, printing the edge sub-reflective strip 108e3 along the edge sub-path may include the follows: the print head travels along the direction D1 parallel to the side edge S1a of the light-emitting device for a certain distance, and then travels along the direction D2 parallel to the side edge S2d of the light-emitting device to a position close to the center point of the side edge S2d, and changes the travel direction thereof to travel along the direction D1 and other sub-paths.

Thereafter, the print head travels from other sub-paths to a position close to the center point of the side edge S2d, and prints an edge sub-reflective strip 108e4 along an edge sub-path, and the edge sub-reflective strip 108e4 may surround part of the side edges of the light-emitting device LD, for example, may surround a portion of the side edge S2d and a portion of the side edge S1b. For example, printing the edge sub-reflective strip 108e4 along the edge sub-path may include the follows: the print head travels along the direction D2 parallel to the side edge S2d of the light-emitting device for a certain distance, and then travels along the direction D1 parallel to the side edge S1b of the light-emitting device to a position close to the center point of the side edge S2d, and then travels along the sub-path of the direction D2.

In this embodiment, there are other sub-paths between the plurality of edge sub-paths, and the edge sub-reflective strips formed by adjacent edge sub-paths are connected to each other to form the edge part of the reflective layer surrounding the light-emitting device LD, and define the reflective layer opening OP1. That is, the edge sub-reflective strips 108e1-108e4 are connected to each other and enclose to form the reflective layer opening OP1. In some embodiments, adjacent edge sub-reflective strips may overlap with each other in a direction perpendicular to the base substrate. The edge sub-reflective strips 108e1-108e4 each surround a portion of the light-emitting device LD, and may have a rounded chamfer facing a top corner of the light-emitting device.

Referring to FIG. 7A and FIG. 7B, FIG. 7B illustrates traveling directions of the print head in sub-paths by arrows, and arrows corresponding to the same reference numeral indicate the traveling direction(s) in the same one sub-path.

In this embodiment, in the region surrounding the light-emitting device LD, the print head prints a plurality of edge sub-reflective strips 108e1, 108e2, 108e3, 108e4, 108e5, 108e6 along a plurality of edge sub-paths e1, e2, e3, e4, e5, e6, adjacent sub-reflective strips of the plurality of edge sub-reflective strips 108e1-108e6 are connected to and merged with each other, and enclose to form a reflective layer opening OP1, and the adjacent sub-reflective strips of the plurality of edge sub-reflective strips 108e1-108e6 may overlap with each other in a direction perpendicular to the main surface of the base substrate. That is to say, the plurality of edge sub-reflective strips are merged with each other to form the edge part EP of the reflective layer 109a illustrated in FIG. 3C. In some embodiments, the edge sub-reflective strips 108e1 and 108e6 printed along the edge sub-paths e1 and e6, and the edge sub-reflective strips 108e3 and 108e4 printed along the edge sub-paths e3 and e4 are respectively facing opposite side edges the light-emitting device LD, such as the side edge S1b and the side edge S1a, and may each have a "U" shape; wherein the edge sub-reflective strips 108e1 and 108e6 are connected to each other and define a reflective edge of a portion of the edge part, facing the side edge S1b of the light-emitting device LD, of the reflective layer; and the edge sub-reflective strips 108e3 and 108e4 are connected to each other and define a reflective edge of a portion of the edge part, facing the side edge S1a of the light-emitting device LD, of the reflective layer. It should be noted that, in order to clearly illustrate the traveling direction of the edge sub-paths, the two portions extending along the direction D2 of each of the edge sub-reflective strips 108e1 and 108e6, 108e3 and 108e4 are illustrated as being separated from each other in the figure, but it should be understood that the two portions extending along the direction D2 of each of the edge sub-reflective strips 108e1 and 108e6, 108e3 and 108e4 are adjacent to each other, and are connected to each other and overlap with each other to form a continuous reflective layer.

The edge sub-paths e2 and e5 and their corresponding edge sub-reflective strips 108e2 and 108e5 respectively face the side edges S2c and S2d of the light-emitting device LD, and the edge sub-reflective strips 108e2 and 108e5 are each a portion of the sub-reflective strip formed by printing along the path in the direction D2. In this embodiment, the plurality of edge sub-paths are portions of the plurality of primary paths along the direction D2 and secondary paths along the direction D1 close to the periphery of the light-emitting device LD.

Referring to FIG. 8A and FIG. 8B, in some embodiments, the print head travels in a continuous ring-shaped edge path around the light-emitting device LD to form a ring-shaped edge reflective strip 108e. In some embodiments, at least a portion of the ring-shaped edge reflective strip 108e (e.g., a portion close to a side of the light-emitting device LD) forms the edge part EP of the reflective layer 109a illustrated in FIG. 3D. As illustrated in FIG. 8A and FIG. 8B, in some embodiments, the ring-shaped edge path includes sub-paths e1, e2, e3, e4 surrounding the periphery of the light-emitting device LD. The sub-paths e1-e4 are continuous and each extend parallel to a corresponding side edge of the light-emitting device. For example, the print head travels from the printing start point SP along the direction D2 to the sub-path e1 close to the side edge S2d of the light-emitting device LD, then prints the edge reflective strip 108e surrounding the light-emitting device LD in an ring-shaped edge path including sub-paths e1-e4, and then continues to print the reflective material along the sub-path e5 and other sub-paths. The reflective strips formed by the sub-path e5 and the sub-path e1 overlap with each other. In some embodiments, the print head travels from the sub-path e1 to the sub-path e4, then travels along the sub-path e4 in the direction D1 to a position close to the sub-path e1 or overlapping with the sub-path e1, and then changes the direction of the path and travels along the sub-path e5 in the direction D2. The reflective materials printed by the print head at the end part of the sub-path e4, a portion of the sub-path e1 and a portion of the sub-path e5 overlap with each other, so that the edge reflective strip 108e in a shape of a closed ring can be formed. In some embodiments, as described above with reference to FIG. 3D, the included angles A1, A2, and A4 formed by the sub-reflective strips printed by the sub-paths e1-e3 are rounded chamfers. In some embodiments, at the overlapping position OL of the sub-paths e4, e1, and e5, the dimension of the reflective material at the position is relatively large, or the print head prints relatively more reflective material at the position, so that the included angle of the formed edge reflective strip 108e at the overlapping position is also a rounded chamfer A3.

FIG. 9A, FIG. 9B, FIG. 10A and FIG. 10B are schematic top views and cross-sectional views illustrating a method of printing the reflective material in the second printing region according to some other embodiments of the present disclosure, in which FIG. 9B and FIG. 10B are cross-sectional views taken along the lines I-I' of FIG. 9A and FIG. 10A, respectively. It should be understood that, for the sake of brevity of the drawings, other components between the base substrate 100 and the reflective strips are not specifically illustrated in FIG. 10A and FIG. 10B.

In some embodiments, in the second region R2 where no reflective layer openings need to be formed, printing the reflective layer 109b may include printing a first group of reflective strips in a same one second region R2 using a first group of spray valves, and printing a second group of reflective strips in the same one second region R2 using a second group of spray valves. The first group of reflective strips and the second group of reflective strips respectively include a plurality of first reflective strips and a plurality of second reflective strips arranged along the first direction and extending along the second direction, the plurality of first reflective strips are spaced apart from each other, and the plurality of second reflective strips are printed between the plurality of first reflective strips to fill gaps between the plurality of first reflective strips.

Referring to FIG. 9A and FIG. 9B, for example, the first group of spray valves are used to travel along the direction D2 in the second region R2 and print the reflective material, thereby forming a plurality of reflective strips P1 (or referred to as the first group of reflective strips) extending along the direction D2 in the second region R2. The first group of spray valves are spray valves in the same one print head, and the print head may further include more first group of spray valves, so that the print head can simultaneously print first groups of reflective strips in a plurality of second regions.

A plurality of reflective strips P1 extend parallel to each other along the direction D2 and are arranged along the direction D1, and a gap gp is provided between adjacent reflective strips P1. In some embodiments, when viewed from a plan view, as illustrated in FIG. 9A, the reflective strip P1 is of a shape of a strip, such as a rectangle or a similar shape; when viewed from a cross-sectional view, as illustrated in FIG. 9B, the reflective strip P1 is provided with a curved surface, for example, the reflective strip P1 has a thickness tp1 in its central portion, the central portion is at its central position in the direction D1, and the thickness of the reflective strip P1 gradually decreases as being away from the central portion in the direction D1; that is, the thickness tp1 of the central portion of the reflective strip P1 is maximum thickness thereof. It should be understood that, in the embodiments of the present disclosure, the reflective strips printed by the above-mentioned 3D process all have the same or similar shape as the reflective strip P1. In some embodiments, the reflective strip P1 has a width wp1 in the direction D1, and the gap gp between adjacent reflective strips P1 has a width wg; and the width wp1 of the reflective strip P1 may be greater than or equal to the width wg of the gap, but the present disclosure is not limited thereto. In some other embodiments, the width wp1 of the reflective strip P1 may also be smaller than the width wg of the gap. It should be understood that, the width wg is the minimum width between adjacent reflective strips P1, and because the reflective strip has a curved surface, as illustrated in FIG. 9B, the gap gp between adjacent reflective strips P1 gradually increases as being away from the base substrate 100.

Referring to FIG. 10A and FIG. 10B, after printing the first group of reflective strips P1, the second group of spray valves are used to travel along the direction D2 in the second region R2 and print the reflective material, thereby forming a plurality of reflective strips P2 (or referred to as the second group of reflective strips) extending along the direction D2 in the second region R2. It should be understood that, the plurality of reflective strips P1 and the plurality of reflective strips P2 illustrated in the figure are all formed in the same one second region R2. The second group of spray valves are spray valves in a same one print head, and the print head may further include more second groups of spray valves, so that the print head can simultaneously print second groups of reflective strips in a plurality of second regions.

The plurality of reflective strips P2 extend along the direction D2 and are arranged along the direction D1; and the plurality of reflective strips P2 are respectively formed between adjacent reflective strips P1 to fill the gaps gp between the reflective strips P1. In some embodiments, the reflective strip P2 may further be formed between a reflective strip P1 close to the first region R1 and a sub-reflective strip in the first region R1, so as to fill a gap between the reflective strip P1 and the sub-reflective strip in the first region R1, as illustrated in FIG. 3E. The reflective strip P2 and the reflective strip P1 overlap with each other in a direction perpendicular to the main surface of the base substrate 100. In some embodiments, because the reflective strips P2 and P1 are not printed in a continuous printing path, and a certain time interval may be between printing the reflective strip P2 and printing the reflective strip P1, an interface IF2 may exist between the reflective strip P2 and the reflective strip P1.

In some embodiments, when the second group of spray valves print the reflective strip P2, because the reflective material is fluid and surrounded by the reflective strips P1, the cross-sectional shape of the reflective strip P2 is similar to the shape of the gap between the first reflective strips P1, and may be different from the cross-sectional shape of the first reflective strip P1.

In some embodiments, the dimension (e.g., diameter) of each of the second group of spray valves may be the same as or different from the dimension of each of the first group of spray valves, and the dimension of each of the second group of spray valves may be smaller or larger than the dimension of each of the first group of spray valves. The first group of spray valves and the second group of spray valves may be spray valves in the same or different print heads. In some embodiments, the amount of reflective material sprayed by the spray valve can be controlled by selecting a spray valve with an appropriate dimension and/or adjusting the flow rate of the spray valve, thereby controlling the dimension of the reflective strip, and controlling the thickness of the reflective layer formed by the reflective strips P1 and P2 to be uniform, thereby ensuring the light-exiting uniformity of the light-emitting substrate. For example, the difference between the thickness tp2 of the reflective strip P2 and the thickness tp1 of the reflective strip P1 may be within a range of 0 to 5 µm, or the difference between the thicknesses of each portion of the reflective layer 109b formed by the reflective strips P1 and P2 and the thickness tp1 of the reflective strip P1 may be within a range of 0 to 5 µm.

In some embodiments, the above-mentioned printing method is used to form the reflective layer in the same second printing region, which can improve the printing efficiency, and can improve the adhesion and thickness uniformity of the formed reflective layer, thereby improving the light-exiting uniformity of the light-emitting substrate.

FIG. 11 illustrates a schematic cross-sectional view of a display device according to some embodiments of the present disclosure.

Referring to FIG. 11, in some embodiments, a display device 600 includes a backlight module 400 and a display panel 500, and the backlight module 400 includes a light-emitting substrate 200 and an optical film layer 300 disposed on the light-exiting side of the light-emitting substrate. The display panel 500 is disposed on a side of the backlight module 400, for example, on a side of the optical film layer 300 away from the light-emitting substrate 200. The light-emitting substrate 200 may be the light-emitting substrate 200 described in the above embodiments, and may include the reflective layer described in any of the above embodiments.

The backlight module 400 can provide backlight for the display panel 500, the light-emitting device LD on the light-emitting substrate 200 can be used as a backlight source, and the optical film layer 300 can perform brightening treatment, diffusion treatment and/or the like on the light emitted by the light-emitting substrate 200 based on optical principles.

The display substrate 500 may be a liquid crystal display panel, and may include an array substrate, a color filter substrate, and a liquid crystal layer disposed between the array substrate and the color filter substrate. The array substrate may be located on a side close to the backlight module 400.

In some embodiments, the display device 600 may be or include any device with a display function, such as a mobile phone, a computer, a television, a digital camera, a navigator, etc., and the present disclosure is not limited thereto.

In the above-mentioned embodiments, the light-emitting substrate 200 including the reflective layer 109 is applied to the display device 600 as a part of the backlight module 400, and the reflective layer 109 may include reflective materials such as white oil, but the present disclosure is not limited thereto. In addition to being applied to backlight display scenarios, the concepts of the present disclosure can also be applied to other display scenarios, for example, the reflective layer 109 can be slightly modified and/or replaced to be applied to other display scenarios. For example, the reflective layer may be replaced with a black film layer for direct display scenes. It should be understood that the modifications and/or substitutions should all fall within the protection scope of the present disclosure.

The following statements should be noted:
(1) The drawings of the present disclosure involve only the structure(s) in connection with the embodiment(s) of the present disclosure, and other structure(s) can be referred to common design(s).
(2) In case of no conflict, features in one embodiment or in different embodiments can be combined to obtain new embodiments.

What have been described above are only specific implementations of the present disclosure, the protection scope of the present disclosure is not limited thereto. Any modifications or substitutions easily occur to those skilled in the art within the technical scope of the present disclosure should be within the protection scope of the present disclosure. Therefore, the protection scope of the present disclosure should be based on the protection scope of the claims.

## Claims

1. A light-emitting substrate, comprising a first region and a second region alternately disposed along a first direction, and comprising:
a base substrate;
a light-emitting device, disposed on a side of the base substrate and in the first region; and
a reflective layer, located on the side of the base substrate, and comprising a first reflective layer and a second reflective layer respectively located in the first region and the second region and connected to each other,
wherein the reflective layer has an opening, and the light-emitting device is located in the opening and spaced apart from the reflective layer;
the reflective layer comprises an edge part and a body part, the edge part is close to the light-emitting device and defines the opening, the body part is located on a side of the edge part away from the light-emitting device, and the edge part at least comprises a portion of the first reflective layer; and
the edge part of the reflective layer is provided with a plurality of reflective edges facing the light-emitting device and defining the opening, and a plurality of reflective included angles formed by the plurality of reflective edges intersecting with each other, and the plurality of reflective included angles comprise included angles that are not completely identical in shape.

2. The light-emitting substrate according to claim 1, wherein the plurality of reflective included angles of the reflective layer comprise at least one of an acute angle, a rounded chamfer, and an obtuse angle.

3. The light-emitting substrate according to claim 1, wherein the light-emitting device has a first device side edge extending along the first direction and a second device side edge extending along a second direction, the second direction intersects with the first direction, and a first distance from the first device side edge to the reflective layer in the second direction is substantially equal to a second distance from the second device side edge to the reflective layer in the first direction.

4. The light-emitting substrate according to claim 3, wherein the light-emitting device has a plurality of top corners, the plurality of top corners are formed by included angles between the first device side edge and the second device side edge intersecting with each other, the plurality of reflective edges of the reflective layer comprise a first reflective edge facing the first device side edge and a second reflective edge facing the second device side edge, the plurality of reflective included angles of the reflective layer comprise a plurality of included angles formed by the first reflective edge and the second reflective edge intersecting with each other, and each of the plurality of included angles of the reflective layer comprises an acute angle or a rounded chamfer.

5. The light-emitting substrate according to claim 3, wherein the first device side edge of the light-emitting device comprises a group of a first side edge and a second side edge extending parallel to each other along the first direction, and the second device side edge of the light-emitting device comprises a group of a third side edge and a fourth side edge extending parallel to each other along the second direction;
the plurality of reflective edges of the reflective layer comprise a first edge, a second edge, a third edge, and a fourth edge, respectively facing the first side edge, the second side edge, the third side edge, and the fourth side edge of the light-emitting device, and the plurality of reflective included angles of the reflective layer comprise a first included angle which is an included angle between the first edge and the third edge, a second included angle which is an included angle between the second edge and the third edge, a third included angle which is an included angle between the first edge and the fourth edge, and a fourth included angle which is an included angle between the second edge and the fourth edge; and
the first included angle and the second included angle are included angles of a same type, and the third included angle and the fourth included angle are included angles of a same type.

6. The light-emitting substrate according to claim 5, wherein the first edge and the second edge of the reflective layer each comprise a body part extending along the first direction and end parts located at two ends of the body part, and the third edge and the fourth edge each comprise a body part extending along the second direction and end parts located at two ends of the body part; and
the first included angle to the fourth included angle of the reflective layer are respectively formed by end parts of corresponding edges of the first edge to the fourth edge intersecting with each other, and extension directions of the end parts and the body part of at least one of the first edge to the fourth edge of the reflective layer are different.

7. The light-emitting substrate according to claim 6, wherein the first included angle is located on a side of an extension line of the body part of the first edge in the first direction, away from a centerline of the light-emitting device, and the second included angle is located on a side of an extension line of the body part of the second edge in the first direction, away from the centerline of the light-emitting device, and the centerline of the light-emitting device extends along the first direction and passes through a center of the light-emitting device.

8. The light-emitting substrate according to claim 7, wherein the third included angle is located on a side of the extension line of the body part of the first edge, close to the centerline of the light-emitting device, and the fourth included angle is located on a side of the extension line of the body part of the second edge, close to the centerline of the light-emitting device.

9. The light-emitting substrate according to claim 7, wherein the third included angle is located on a side of the extension line, of the body part of the first edge, away from the centerline of the light-emitting device, and the fourth included angle is located on a side of the extension line, of the body part of the second edge, away from the centerline of the light-emitting device.

10. The light-emitting substrate according to claim 6, wherein the first included angle to the fourth included angle are each located on a side of extension lines, of the body parts of the first edge and the second edge in the first direction, close to a centerline of the light-emitting device, and the centerline of the light-emitting device extends along the first direction and passes through a center of the light-emitting device.

11. The light-emitting substrate according to claim 6, wherein the end parts of the first edge to the fourth edge on opposite sides of a centerline of the light-emitting device comprise curves with different curvatures.

12. The light-emitting substrate according to claim 5, wherein the first edge and the second edge of the reflective layer each comprise a first sub-edge and a second sub-edge intersecting with each other, and the reflective layer is provided with a recess, recessed toward the body part of the reflective layer and away from the light-emitting device, at an intersection of the first sub-edge and the second sub-edge.

13. The light-emitting substrate according to claim 12, wherein the intersection of the first sub-edge and the second sub-edge is aligned in the second direction with a center point of the first device side edge of the light-emitting device in the first direction.

14. The light-emitting substrate according to claim 12, wherein an included angle between the first sub-edge and the second sub-edge is an obtuse angle.

15. The light-emitting substrate according to claim 12, wherein each of the third edge and the fourth edge of the reflective layer also comprises a first sub-edge and a second sub-edge intersecting with each other, and the reflective layer is provided with a recess, recessed toward the body part of the reflective layer and away from the light-emitting device, at an intersection of the first sub-edge and the second sub-edge.

16. The light-emitting substrate according to claim 15, wherein the intersection of the first sub-edge and the second sub-edge of each of the third edge and the fourth edge of the reflective layer is aligned in the first direction with a center point of the second device side edge of the light-emitting device in the second direction.

17. The light-emitting substrate according to claim 1, wherein a thickness of the edge part is less than a thickness of the body part.

18. The light-emitting substrate according to claim 17, wherein the edge part is ring-shaped and laterally surrounds the light-emitting device.

19. The light-emitting substrate according to claim 17, wherein the edge part is a portion of the first reflective layer close to the light-emitting device, and the edge part is spaced apart from the second reflective layer by other portions of the first reflective layer.

20. The light-emitting substrate according to claim 17, wherein the edge part comprises a first edge part of the first reflective layer and a second edge part of the second reflective layer, and the first edge part and the second edge part enclose to form the opening.

21. The light-emitting substrate according to claim 20, wherein a side length of the first edge part is greater than a side length of the second edge part.

22. The light-emitting substrate according to claim 1, wherein a thickness of a body part of the first reflective layer is substantially equal to a thickness of a body part of the second reflective layer.

23. The light-emitting substrate according to claim 1, wherein the second reflective layer comprises a plurality of first reflective strips and second reflective strips arranged alternately along the first direction and extending along a second direction, one of the second reflective strips is located between adjacent first reflective strips, and overlaps with the adjacent first reflective strips in a direction perpendicular to a main surface of the base substrate.

24. The light-emitting substrate according to any one of claims 1-23, wherein a plurality of the first regions and a plurality of the second regions are arranged alternately along the first direction, and the light-emitting device comprises a plurality of light-emitting devices arranged in an array in the plurality of the first regions.

25. The light-emitting substrate according to claim 24, further comprising an additional device arranged between adjacent light-emitting devices in the first direction, wherein in the first direction, a pitch between adjacent additional devices is an integer multiple of a pitch between the adjacent light-emitting devices.

26. The light-emitting substrate according to claim 25, wherein the reflective layer further comprises an additional opening, and the additional device is disposed in the additional opening of the reflective layer and spaced apart from the reflective layer.

27. A manufacturing method of a light-emitting substrate, wherein the light-emitting substrate comprises a first region and a second region alternately disposed along a first direction, and the manufacturing method comprises:
providing a base substrate;
forming a conductive pad over the base substrate;
bonding a light-emitting device to the conductive pad, wherein the light-emitting device is disposed in the first region; and
forming a reflective layer over the base substrate by using a 3D printing process after bonding the light-emitting device, wherein forming the reflective layer comprises forming a first reflective layer in the first region and forming a second reflective layer in the second layer, and the first reflective layer and the second reflective layer are connected to each other;
the reflective layer is provided with an opening, and the light-emitting device is located in the opening and spaced apart from the reflective layer;
the reflective layer comprises an edge part and a body part, the edge part is close to the light-emitting device and defines the opening, the body part is located on a side of the edge part away from the light-emitting device, and the edge part at least comprises a portion of the first reflective layer; and
the edge part of the reflective layer is provided with a plurality of reflective edges facing the light-emitting device and defining the opening, and a plurality of reflective included angles formed by the plurality of reflective edges intersecting with each other, and the plurality of reflective included angles comprise included angles that are not completely identical in shape or angle degree.

28. The manufacturing method of the light-emitting substrate according to claim 27, wherein the 3D printing process comprises printing the first reflective layer in the first region by using a first print head and printing the second reflective layer in the second region by using a second print head, a plurality of reflective strips are printed in the first region and the second region by the first print head and the second print head each according to a predetermined printing path, and the plurality of reflective strips are merged together with each other to form the reflective layer.

29. The manufacturing method of the light-emitting substrate according to claim 28, wherein a dimension of a spray valve of the first print head is smaller than a dimension of a spray valve of the second print head;
printing the first reflective layer comprises that the first print head travels along a first sub-path in a second direction to print a first sub-reflective strip, then moves in the first direction by a first offset distance, and travels in the second direction along a second sub-path opposite to a direction of the first sub-path to print a second sub-reflective strip;
printing the second reflective layer comprises that the second print head travels along a third sub-path in the second direction to print a third sub-reflective strip, then moves in the first direction by a second offset distance, and travels in the second direction along a fourth sub-path opposite a direction of the third sub-path to print a fourth sub-reflective strip; and
the first offset distance is less than the second offset distance.

30. The manufacturing method of the light-emitting substrate according to claim 29, wherein the first sub-reflective strip and the second sub-reflective strip overlap with each other in a direction perpendicular to a main surface of the base substrate, the third sub-reflective strip and the fourth sub-reflective strip overlap with each other in the direction perpendicular to the main surface of the base substrate, and a width of an overlapping region of the first sub-reflective strip and the second sub-reflective strip in the second direction is greater than a width of an overlapping region of the third reflective strip and the fourth reflective strip in the second direction.

31. The manufacturing method of the light-emitting substrate according to claim 29, wherein printing the first reflective layer further comprises: when the first print head travels to a position close to the light-emitting device, changing a moving direction of the first print head to bypass the light-emitting device, and printing an edge reflective material layer along a periphery of the light-emitting device at a position separated from the light-emitting device by a predetermined distance, wherein a boundary of at least a portion of the opening of the reflective layer is defined by the edge reflective material layer printed by the first print head.

32. The manufacturing method of the light-emitting substrate according to claim 31, wherein the first print head prints a first edge reflective strip along a part of the periphery of the light-emitting device, and printing the second reflective layer further comprises: printing a second edge reflective strip, wherein the second edge reflective strip and the first edge reflective strip are connected to each other and enclose to form the opening.

33. The manufacturing method of the light-emitting substrate according to claim 31, wherein a boundary of the opening of the reflective layer is entirely defined by the edge reflective material layer printed by the first print head, and printing the edge reflective material layer by the first print head comprises printing an ring-shaped edge reflective strip by the first print head along an ring-shaped path surrounding the light-emitting device, or printing a plurality of edge sub-reflective strips by the first print head along a plurality of edge sub-paths surrounding the light-emitting device, and the plurality of edge sub-reflective strips are connected to each other and enclose to define the opening.

34. The manufacturing method of the light-emitting substrate according to claim 27, wherein printing the second reflective layer comprises printing a first group of reflective strips by using a first group of spray valves, and printing a second group of reflective strips by using a second group of spray valves,
the first group of reflective strips comprise a plurality of first reflective strips, the second group of reflective strips comprise a plurality of second reflective strips, and the plurality of first reflective strips and the plurality of second reflective strips are arranged along the first direction and extending along a second direction,
the plurality of first reflective strips are spaced apart from each other, and the plurality of second reflective strips are printed between the plurality of first reflective strips to fill gaps between the plurality of first reflective strips,
wherein the first group of reflective strips and the second group of reflective strips overlap with each other in a direction perpendicular to a main surface of the base substrate.

35. A backlight module, comprising the light-emitting substrate according to any one of claims 1-26, and an optical film layer located on a light-exiting side of the light-emitting substrate.

36. A display device, comprising the backlight module according to claim 35, and a display panel located on a side of the backlight module.
